# EUROPÄISCHE PATENTSCHRIFT

(11) **EP 3 858 606 B1**
(45) Veröffentlichungstag und Bekanntmachung des Hinweises auf die Patenterteilung: **07.09.2022**
(21) Anmeldenummer: 20153987.1
(22) Anmeldetag: 28.01.2020
(51) Int. Cl.: B32B 17/10, C03C 17/00, E04C 2/54, H01L 31/048, H01L 31/0236, H01L 31/054, H02S 20/22, E04F 13/14

(54) **FARBIGES FASSADENELEMENT MIT VERBUNDSCHEIBENSTRUKTUR**
COLOURED FACADE ELEMENT WITH LAMINATED PANE STRUCTURE
ÉLÉMENT DE FAÇADE COLORÉE À STRUCTURE DE VITRE COMPOSITE

(43) Veröffentlichungstag der Anmeldung: 04.08.2021
(73) Patentinhaber: CNBM RESEARCH INSTITUTE FOR ADVANCED GLASS MATERIALS GROUP CO., LTD., Bengbu, Anhui 233010 (CN)
(72) Erfinder: Palm, Jörg, 80797 München (DE); Tautenhahn, Lutz, 01277 Dresden (DE)
(74) Vertreter: Ipey

(56) Entgegenhaltungen:
- EP-A1- 2 793 271
- EP-A1- 3 129 810
- EP-A2- 2 897 795
- EP-B1- 2 897 795
- EP-B1- 3 129 810
- WO-A1-2018/154045
- US-A1- 2014 104 690

## Beschreibung

Die vorliegende Erfindung liegt auf dem technischen Gebiet der Fassadenfertigung und betrifft ein farbiges Fassadenelement mit Verbundscheibenstruktur.

Die Verwendung von Solarmodulen als Wand- bzw. Fassadenelemente ist derzeit ein wirtschaftlich noch relativ geringer, jedoch ökologisch sehr interessanter Markt. Insbesondere angesichts verstärkter Bemühungen für dezentrale Energielösungen und energieneutrale Gebäude wächst der Bedarf für die Anwendung von Solarmodulen als integrierte Bestandteile von Gebäudehüllen. Weitere interessante Anwendungsbereiche für Solarmodule sind Lärmschutzwände (Straße, Schiene), Sichtschutzwände im Außenbereich oder Wände für Gewächshäuser. Diese neuen Anwendungen stellen völlig neue Anforderungen an Solarmodule, insbesondere im Hinblick auf Ästhetik, Lebensdauer und weitere Funktionalitäten wie Abdichtung und Wärmeisolation. Insbesondere müssen die hierfür eingesetzten Solarmodule in verschiedenen Formen, Größen und Farben zur Verfügung stehen und einen möglichst homogenen Farbeindruck vermitteln. Je nach Ursprung der Farbe (Absorption/Remission, Interferenz, Brechung) kann die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichts den Farbeindruck.

Ein ideales Solarmodul wäre hinsichtlich Wirkungsgradoptimierung ein schwarzer Körper, der das auftreffende Sonnenlicht vollständig absorbiert, um die Strahlungsenergie optimal in elektrische Energie umzuwandeln. Jedoch wird von jedem realen Körper auftreffende Strahlung reflektiert und absorbierte Strahlung remittiert, wobei der Farbeindruck im menschlichen Auge grundsätzlich aus der spektral selektierten Reflexion und der Remission von Licht entsteht. Das Sonnenspektrum hat im sichtbaren Spektralbereich die höchste Energieintensität und das menschliche Auge die größte Empfindlichkeit. Wird ein Solarmodul farbig gestaltet, d.h. soll im menschlichen Auge ein Farbeindruck des Solarmoduls erzeugt werden, der vom idealen schwarzen Körper verschieden ist, reduziert man zwingend die Intensität des im fotovoltaisch aktiven Halbleiter absorbierten Lichts und damit auch die elektrische Leistung bzw. den Wirkungsgrad des Solarmoduls. Ein optimaler Wirkungsgrad kann grundsätzlich nur mit einem schwarzen Solarmodul erzielt werden. Andererseits kann, je nach Ursprung der Farbe (Absorption/Remission, Interferenz, Brechung), die Farbe einer an sich homogenen Oberfläche des Solarmoduls vom Betrachtungs- und/oder Einstrahlwinkel abhängen. Darüber hinaus bestimmen auch das Spektrum und die räumliche Verteilung (diffus, gerichtet) des Lichtes den Farbeindruck.

Aus dem Stand der Technik EP 3 129 810 A1 , EP 2 793 271 A1, EP 2 897 795 A2, WO 2018/154045 A1 sind gattungsgemäße und ähnliche Fassadenelemente bekannt. US 2014/104690 A1 zeigt eine Strukturierung zur Lichtstreuung für Glassscheiben.

In den nicht-veröffentlichten europäischen Patentanmeldungen EP 1818615 und EP18186161 sind Solarmodule gezeigt, bei denen eine Farbgebung durch mindestens eine optische Interferenzschicht erfolgt. Durch Strukturieren des Frontglases wird ein farbiges Solarmodul erhalten, das auch aus verschiedenen Blickrichtungen und bei unterschiedlichen Lichtverhältnissen eine für das menschliche Auge weitgehend stabile Farbwirkung hat und dabei immer noch eine akzeptable Energieausbeute, insbesondere einen guten Wirkungsgrad, erreicht.

Die konkrete Dimensionierung einer Fassade kann erfordern, dass farbige Solarmodule in verschiedenen Größen und Formen benötigt werden, um der Fassade eine möglichst homogene Farbe zu geben. Generell führen kleinere und nicht rechteckförmige Solarmodule zu erheblichen Mehrkosten, wenn der eigentliche Halbleiterstapel auf großer Fläche hergestellt wird und kleinere Modulgrößen durch Teilen erzeugt werden müssen, da bei kleineren Solarmodulen ein deutlich höherer Materialeinsatz pro Einheit Ausgangsleistung erforderlich ist. Zudem wird bei kleineren Solarmodulen das Verhältnis von Modulfläche zu Modulrand ungünstiger, so dass auch der Gesamtmodulwirkungsgrad kleiner ist. Ferner haben die Kosten von bestimmten Materialien und Fixkosten für Anbauteile und Randversiegelung bei kleinen Solarmodulen einen höheren Anteil an den Gesamtkosten. Des Weiteren können bestimmte Schritte des Herstellungsprozesses bei verschiedenen Substratgrößen nur mit stark modifizierten Anlagenkonzepten umgesetzt werden.

Aus vorstehend genannten Gründen ist die industrielle Serienfertigung von Solarmodulen auf einige wenige Standard-Modulgrößen und in aller Regel Rechteckform der Solarmodule ausgerichtet, so dass eine vollflächige Belegung einer Fassade mit Solarmodulen meist nicht möglich oder wirtschaftlich inakzeptabel ist. Hinzu kommt, dass die fotovoltaische Auslegung der Solarzellen und diverse Anbauteile wie Kontaktbänder, Anschlussdosen und Kabel für die Standard-Modulgrößen optimiert sind. Darüber hinaus kann es durch eine ungünstige Ausrichtung zur Sonne oder durch Verschattung durch Teile desselben Gebäudes oder durch benachbarte Gebäude unwirtschaftlich sein, bestimmte Bereiche einer Fassade mit Solarmodulen zu belegen, da deren Energieertrag nicht die Mehrkosten erwirtschaftet.

Um das Problem fehlender geeigneter Größen und/oder Formen von farbigen Solarmodulen zu beheben, ist denkbar, fotovoltaisch passive Fassadenelemente aus Blech oder anderen herkömmlichen Baumaterialien zu verwenden, wobei es sich versteht, dass deren Farbe möglichst ähnlich zu jener der farbigen Solarmodule sein sollte. Hier gibt es aber ein technisches und gestalterisches Problem, das in der Natur der Farberzeugung liegt. Tatsächlich kann sich die Farbe der Solarmodule, je nach Ursprung der Farbe (Absorption/Remission, Interferenz, Brechung) bei unterschiedlichen Beleuchtungsverhältnissen, insbesondere abhängig von der Art des Lichtes (diffus, direkt, Lichtfarbe), sowie durch eine Änderung des Einstrahl- und/oder Beobachtungswinkels verändern. Wenn die fotovoltaisch passiven Fassadenelemente aus anderen Materialien als die farbigen Solarmodule bestehen, entstehen hierdurch typischerweise Farbkontraste, die aus gestalterischen Gesichtspunkten unerwünscht sind.

Eine Lösung dieses Problems geht aus der nicht-veröffentlichten europäischen Patentanmeldung EP 18186175 hervor. Darin gezeigt sind fotovoltaisch passive Fassadenelemente, bei denen analog zu den nicht-veröffentlichten europäischen Patentanmeldungen EP 1818615 und EP18186161 das Frontglas eine Strukturierung aufweist und mindestens eine optische Interferenzschicht vorgesehen ist.

Bei vorgehängt-hinterlüfteten Fassaden ist das Fassadenelement durch eine Luftschicht von den dahinterliegenden Strukturen getrennt. Nach DIN 18516-1 setzt sich eine solche Konstruktion aus Fassadenbekleidung, Hinterlüftungszone, Wärmedämmung und Unterkonstruktion zusammen. Voraussetzung ist ein statisch tragender Verankerungsgrund. Auch wird die Wärmedämmung hinterlüftet, um eine Abtrocknung von Kondenswasser zu ermöglichen. Möglich sind unterschiedliche Fassadenbekleidungen, wobei neben Materialien wie Holz, Metall, Verbundmaterialien auch farbige Glaspaneele verwendet werden können, die über Linienhalterungen, Punkthalterungen oder Klemmen befestigt werden. Als Fassadenelemente eignen sich insbesondere auch Solarmodule mit einem 3 - 4 mm dicken Frontglas, einem 2 mm dicken Substratglas mit CIGS-Dünnschichtsolarzellen in monolithischer Serienverschaltung und geklebten Rückseitenschienen (Backrails), wie sie von der Anmelderin vertrieben werden.

Alternativ zur vorgehängt-hinterlüfteten Fassade finden auch Vorhangfassaden weite Verbreitung. Aus statischer Sicht gehört die Pfosten-Riegel-Fassade, zusammen mit der Elementfassade, zu den Vorhangfassaden. Vorhangfassaden sind selbsttragend und übernehmen weitestgehend keine weiteren strukturelle Lasten aus anderen Gebäudeteilen. Ihre Unterkonstruktion wird am Primärtragwerk eines Gebäudes befestigt. In der Produktnorm DIN EN 13830 (Vorhangfassaden) sind die allgemeinen Anforderungen an eine Pfosten-Riegel-Fassade geregelt. Mit der Pfosten-Riegel-Fassade lassen sich großflächige Öffnungen aber auch ganze Fassadenflächen herstellen. Durch variable Profilabmessungen, speziell in Profiltiefe und durch die Verwendung unterschiedlicher Materialien, wie z.B. Holz, Stahl oder Aluminium, können die Konstruktionen auf nahezu jede Einbausituation abgestimmt werden, zumal als Ausfachungen verschiedene Materialien gewählt werden können, wie zum Beispiel Isoliergläser und Solarmodule. Die modulare Bauweise der Pfosten-Riegel-Fassade erlaubt sowohl die Vorfertigung der Elemente im Werk (Elementfassade), als auch ihre Verbindung auf der Baustelle vor Ort. Die Konstruktion basiert auf der Verbindung vertikaler Pfostenprofile (Hauptprofile) und horizontaler Riegelprofile, die zusammen eine skelettartige Tragstruktur ergeben. Der Hauptlastabtrag erfolgt über die senkrechten Pfosten. An diese werden die Riegel entweder geschraubt, gesteckt oder geschweißt angeschlossen. Ausfachungen können aus transparenten oder opaken Materialien bestehen. Zwischen Fassadenfeldern und dem tragenden Fassadengerüst werden elastische Dichtungselemente verwendet.

Ebenfalls von Interesse ist der Einbau von Solarmodulen in große Fensterwände. Diese können integriert sein in Außenwände mit verschiedenen Konstruktionsformen (z.B. auch zwischen gemauerten Außenwänden). Die Solarmodule können beispielsweise als opake Elemente in bodentiefe Fensterelemente eingebaut werden. Alternativ befinden sich in einem Fensterelement im unteren Bereich ein fotovoltaisch aktives Segment und im oberen Bereich ein transparentes Segment.

Bei der Integration von Solarmodulen als Fassadenelemente in eine vorgehängt-hinterlüftete Fassade, eine Vorhangfassade oder eine Fensterwand sollten folgende Anforderungen erfüllt sein:

### Homogene Farbwirkung:

Aus statischen, aber auch aus wirtschaftlichen Gründen sollten die Fassadenelemente eine bestimmte Mindestgröße haben. Die Größe sollte sowohl nach statischen als auch architektonisch-ästhetischen Gesichtspunkten variabel einstellbar sein. Diese Anforderung kann im Konflikt mit den aus der Solarmodulproduktion verfügbaren Größen stehen. Bei Dünnschicht-Solarmodulen stehen in aller Regel aus produktionstechnischen Gründen nur bestimmte Breiten und Längen zu Verfügung. Daher müssen bei größeren Flächen mehrere Module neben- oder untereinander in ein Fassadenelement für Pfosten-Riegel Konstruktion integriert werden. Dazwischen entstehen Bereiche (Kontaktbänder, Randbereiche zu Isolation usw.), die eine andere Farbwirkung haben als die foltovoltaisch aktive Fläche. Bei Solarmodulen in Silizium-Wafer-Technologie gibt es ebenfalls Bereiche (Kontaktgrid, Kontaktbänder, Zwischenräume zwischen den Zellen), die eine andere Farbwirkung haben, als die eigentlichen Zellen. Darüber hinaus haben sowohl Dünnschichtsolarzellen als auch Silizium-Wafer-Solarzellen eine eng begrenzte eigene Farbwirkung (grau, blau oder schwarz). Die eigentliche Zellfläche und die nicht-aktiven Bereiche sollen homogen überdeckt werden mit einer einheitlichen Farbe, möglichst wahlfrei nach Wunsch des Anwenders. Dabei darf der Wirkungsgradverlust nicht zu hoch sein, da sonst der Energieertrag der Fassade zu gering ist.

### Mechanische Stabilität:

Solarmodule bestehen meist aus Glaspaketen (gehärtet und/oder ungehärtet) mit relativ dünnen Glasdicken, zum Beispiel 3 mm ESG Frontglas plus 2 mm ungehärtetes Substratglas bei einem CIGS-Dünnschichtsolarmodul oder 4 mm gehärtetes Frontglas plus Rückseitenfolie bei Standard-Silizium-Solarmodulen. Diese Glasdicken genügen meist nicht für die Ausfachungen einer Pfosten-Riegel-Glaskonstruktion oder für ein Paneel für die Bekleidung einer vorgehängt-hinterlüfteten Fassade, insbesondere bei höheren Gebäuden und/oder höheren Windlastzonen. Für große Gebäudehöhen steigen die Anforderungen an die Windbeanspruchbarkeit, wobei es wünschenswert ist, in höhere Windlastzonen und Gebäudehöhen vorzudringen.

### Klimastabilität:

Im Gegensatz zu herkömmlichen Fassadenmaterialien bestehen Solarmodule aus elektronischen Bauelementen (im Wesentlichen großflächige Halbleiter-Dioden und deren Kontaktelemente), die gegen Feuchtigkeit und andere Umwelteinflüsse geschützt werden müssen. Dies wird in der Regel durch geeignete Verkapselungsmaterialien und Randversiegelungen gewährleistet.

### Herstellungskosten:

Bisher werden gebäude-integrierte Solarmodule meist manuell oder halbautomatisch gefertigt. Dies führt zu relativ hohen Herstellungskosten. Gebäude-integrierte Fotovoltaik kann nur dann zu einem nachhaltig wachsenden Anwendungsfeld werden, wenn die Herstellungskosten einerseits und die Erträge durch Energieerzeugung andererseits zu einer akzeptablen Amortisationszeit für die Mehrkosten der Fassade führen.

### Wirkungsgrad:

Um für die Fassadenintegration eine akzeptable Amortisationszeit für die Mehrkosten der Fassade durch den elektrischen Energieertrag zu erreichen, darf der Wirkungsgrad und der ganzjährig gemittelte Energieertrag nicht zu gering sein.

Demgegenüber besteht die Aufgabe der vorliegenden Erfindung darin, ein farbiges Fassadenelement mit Verbundscheibenstruktur zur Verfügung zu stellen, das obige Anforderungen berücksichtigt. Insbesondere soll die Farbe des Fassadenelements möglichst wenig von den Lichtverhältnissen sowie vom Betrachtungs- und Einstrahlwinkel abhängen. Das Fassadenelement soll in verschiedenen Größen und Formen zu akzeptablen Kosten und mit zufriedenstellender Homogenität herstellbar sein. Zudem soll es gesteigerte Anforderungen an die Windbeanspruchbarkeit erfüllen, so dass es in Zonen mit höherer Windlast und bei größeren Gebäudehöhen einsetzbar ist.

Diese und weitere Aufgaben werden nach dem Vorschlag der Erfindung durch ein Fassadenelement mit den Merkmalen des unabhängigen Patentanspruchs gelöst. Vorteilhafte Ausgestaltungen der Erfindung sind durch die Merkmale der Unteransprüche angegeben.

Erfindungsgemäß ist ein farbiges Fassadenelement mit Verbundscheibenstruktur gezeigt.

Der Begriff "Fassadenelement" bezieht sich generell auf ein Bauteil, das geeignet und bestimmt ist, als sichtbares Flächenelement in eine Fassade eingebaut zu werden. Generell weist die Fassade eine Vorder- bzw Außenseite und eine Rück- bzw. Innenseite auf, wobei die Vorderseite der Fassade von der äußeren Umgebung her betrachtet werden kann. Die Fassade ist beispielsweise eine Gebäudewand oder eine freistehende Wand, die beispielsweise als Sicht- oder Lärmschutzwand dient. Das Fassadenelement kann als eigenständiger Bestandteil in eine Fassade integriert werden, wobei die Vorderfläche des Fassadenelements Teil der Außenseite bzw. Vorderfläche der Fassade ist. Die Vorder- bzw. Außenseite des Fassadenelements dient dem Lichteinfall (z.B. Sonnenlicht) auf das Fassadenelement. Die Rück- bzw. Innenseite des Fassadenelements dient weder der Betrachtung von der äußeren Umgebung her, noch dient sie dem Lichteinfall.

Unter einem "farbigen" Fassadenelement" bzw. "Fassadenelement mit Farbwirkung" ist zu verstehen, dass die Vorder- bzw. Außenseite des Fassadenelements bei Lichteinfall (z.B. Sonnenlicht) eine bestimmte (wählbare) Farbe hat.

Unter "Verbundscheibenstruktur" ist zu verstehen, dass das Fassadenelement mindestens zwei Scheiben aufweist, die durch eine Zwischenschicht fest miteinander verbunden (z.B. laminiert) sind.

Das Fassadenelement kann fotovoltaisch aktiv (d.h. zur fotovoltaischen Stromerzeugung geeignet und bestimmt) sein. Möglich ist jedoch auch, dass das Fassadenelement im Unterschied hierzu fotovoltaisch passiv ist.

Erfindungsgemäß ist ein Fassadenelement mit Farbwirkung gezeigt, das eine transparente oder semitransparente erste Scheibe und eine transparente zweite Scheibe, die durch eine transparente Zwischenschicht fest miteinander verbunden sind, umfasst. Die erste und zweite Scheibe bilden eine Verbundscheibe. Die Zwischenschicht ist vorzugsweise eine thermoplastische oder vernetzende Polymer-Zwischenschicht (z.B. PVB = Polyvinylbutyral oder EVA = Ethylenvinylacetat), welche die beiden Scheiben verklebt. Eine Verklebung ist auch durch ein transparentes Silikon oder Gießharz möglich.

Im Sinne vorliegender Erfindung bezieht sich der Begriff "Transparenz" bzw. "transparent" auf eine Durchlässigkeit für sichtbares Licht von wenigstens 85%, insbesondere wenigstens 90%, vorzugsweise wenigstens 95%, insbesondere 100%. Typischer Weise liegt sichtbares Licht im Wellenlängenbereich von 380 nm bis 780 nm vor. Der Begriff "Opazität" bzw. "opak" bezieht sich auf eine Durchlässigkeit für sichtbares Licht von weniger als 5%, insbesondere 0%. Der Begriff "Semi-Transparenz" bzw. "semi-transparent" bezieht sich auf eine Durchlässigkeit für sichtbares Licht von weniger als 85% und mehr als 5%. Die prozentualen Angaben beziehen sich auf die Intensität des Lichts, jeweils gemessen auf der einen Seite der zu untersuchenden flächigen Struktur (z.B. Scheibe), bezogen auf die Intensität des auf der anderen Seite der flächigen Struktur auftreffenden Lichts. Für eine solche Messung kann beispielsweise eine Weißlichtquelle (Quelle für sichtbares Licht) auf der einen Seite der flächigen Struktur und ein Detektor für sichtbares Licht auf der anderen Seite der flächigen Struktur angeordnet werden. Die nachfolgend genannten Werte für den optischen Brechungsindex beziehen sich immer auf den optischen Brechungsindex im sichtbaren Wellenlängenbereich von 380 nm bis 780 nm. Im erfindungsgemäßen Fassadenelement dient die transparente oder semitransparente erste Scheibe zur Farbgebung, wie im Weiteren näher erläutert wird. Da die erste Scheibe eine farbige Reflexion aufweist, ist sie nicht mehr vollständig transparent. Bei dunkleren und ungesättigten Farben kann die Durchlässigkeit für sichtbares Licht noch mehr als 85% betragen, bei helleren und stärker gesättigten Farben liegt sie in der Regel unter 85%. Die transparente zweite Scheibe dient nicht zur Farbgebung, sondern zur mechanischen Unterstützung bzw. Verstärkung des Fassadenelements, so dass das Fassadenelement auch größeren Anforderungen an die Windbeanspruchbarkeit genügt.

Die farbgebende erste Scheibe weist eine lichteinfallseitig angeordnete Vorderfläche und eine gegenüberliegende Rückfläche auf. Die Vorderfläche der ersten Scheibe ist somit der äußeren Umgebung zugewandt, von der aus die Vorder- bzw. Außenseite des Fassadenelements betrachtet werden kann. Die Rückfläche der ersten Scheibe ist dementsprechend von der äußeren Umgebung abgewandt.

Gemäß einer Ausgestaltung des erfindungsgemäßen Fassadenelements bestehen die Scheiben des Fassadenelements aus einem selben Material, beispielsweise Glas oder Kunststoff, vorzugsweise Kalknatronglas. Vorzugsweise sind die Scheiben jeweils als eine starre Glas- oder Kunststoffplatte ausgebildet. Die Vorderfläche bzw. Rückfläche einer Scheibe wird in diesem Fall vom jeweiligen Material der Scheibe gebildet. Gemäß einer alternativen Ausgestaltung kann eine Scheibe aus mindestens zwei verschiedenen Materialien bestehen, wobei die Vorderfläche und/oder Rückfläche der Scheibe aus einem von einem Kern der Scheibe verschiedenen Material gebildet wird. Der Kern der Scheibe besteht vorzugsweise aus einem gleichen Material, beispielsweise Glas oder Kunststoff, vorzugsweise Kalknatronglas. Auf den Kern der Scheibe ist außen- und/oder innenseitig ein vom Kern der Scheibe verschiedenes Material angebracht, welches transparent ist und einen selben optischen Brechungsindex wie das Material des Kerns der Scheibe hat. Die Vorderfläche bzw. Rückfläche der Scheibe wird in diesem Fall vom jeweiligen Material gebildet, das auf den Kern der Scheibe aufgebracht ist. Erfindungsgemäß umfasst der Begriff "Scheibe" somit auch Verbundkörper, mit der Maßgabe, dass die Materialien, welche die Scheibe formen, nicht absorbierend sind und einen gleichen optischen Brechungsindex haben.

Vorzugsweise weisen die Scheiben des Fassadenelements keine Krümmung auf und sind somit plan (eben). Die Scheiben können jedoch auch gekrümmt sein. Die Scheiben können starr oder biegsam sein. Eine biegsame Scheibe kann auch in ebener Form bereitgestellt werden. Bei einer ebenen (planen) Scheibe wird durch die Scheibe selbst eine Ebene definiert, welche im Sinne der Erfindung als "Ebene der Scheibe" zu verstehen ist. Bei einer gekrümmten Scheibe kann durch eine (gedachte) ebene Tangentialfläche an einem beliebigen Punkt der Ebene eine lokale Ebene definiert werden, welche ebenfalls unter den Begriff "Ebene der Scheibe" fällt.

Das erfindungsgemäße Fassadenelement vermittelt dem Betrachter bei Beleuchtung von der Außenseite her mit weißem Licht, insbesondere bei Beleuchtung mit Sonnenlicht, in mindestens einem Abschnitt einen homogenen Farbeindruck, d.h. das Fassadenelement ist farbig. Vorzugsweise erstreckt sich der farbige Abschnitt über die komplette Vorderfläche des Fassadenelements. Als besonders attraktiv gelten Fassadenelemente mit einem homogenen Farbeindruck auf der gesamten Fläche.

Die Farbe des Fassadenelements kann durch drei Farbkoordinaten L*, a*, b* beschrieben werden, wobei sich die Farbkoordinaten auf den dem Fachmann an sich bekannten (CIE)L*a*b*-Farbraum beziehen, in dem alle wahrnehmbaren Farben exakt definiert sind. Dieser Farbraum ist in der europäischen Norm EN ISO 11664-4 "Colorimetry - Part 4:CIE 1976 L*a*b* Colour space" spezifiziert, auf welche im Rahmen der vorliegenden Erfindungsbeschreibung vollumfänglich Bezug genommen wird. Im (CIE)L*a*b*-Farbraum ist jede Farbe durch einen Farb-Ort mit den drei kartesischen Koordinaten L*, a*, b* definiert. Auf der a*-Achse liegen sich Grün und Rot gegenüber, die b*-Achse verläuft zwischen Blau und Gelb, die L*-Achse beschreibt die Helligkeit (Luminanz) der Farbe. Für eine anschaulichere Darstellung können die Größen in den Lhc-Farbraum umgerechnet werden, wobei L gleich bleibt und die Sättigung der Radius und h der Winkel eines Farbpunktes in der a*b*-Ebene ist.

Die Farbe des Fassadenelements bezieht sich auf eine Betrachtung von der äußeren Umgebung her, d.h. in Sicht auf die frontseitige Scheibe. Die Farbmessung bzw. die Bestimmung der Farbkoordinaten des Fassadenelements kann in einfacher Weise durch ein im Handel verfügbares Farbmessgerät (Spektralphotometer) erfolgen. Das Farbmessgerät wird zu diesem Zweck auf die Vorderfläche der frontseitigen Scheibe gerichtet, insbesondere auf die Vorderfläche aufgesetzt. Übliche Farbmessgeräte ermöglichen eine normgerechte Farbmessung, wobei deren Aufbau und Toleranzen typischer Weise internationalen Normen unterliegen, beispielsweise definiert durch DIN 5033, ISO/CIE 10527, ISO 7724 und ASTM E1347. Beispielsweise wird hinsichtlich der Farbmessung auf die Norm DIN 5033 vollumfänglich Bezug genommen. Ein Farbmessgerät weist als Lichtquelle beispielsweise eine Xenon-Blitzlampe, Wolfram-Halogenlampe oder ein oder mehrere LEDs auf, wobei die Vorderfläche eines Körpers mit dem erzeugten Licht (z.B. Weiß-Licht) beleuchtet und das vom Fassadenelement empfangene Licht gemessen wird. Wie eingangs erläutert, ergibt sich die vom Farbmessgerät gemessene Körperfarbe aus dem reflektierten und remittierten Licht des Fassadenelements.

Um zu erreichen, dass das erfindungsgemäße Fassadenelement zumindest in einem Abschnitt eine homogene Farbe hat, weist zumindest eine Oberfläche (d.h. Vorderfläche und/oder Rückfläche) der farbgebenden ersten Scheibe mindestens einen strukturierten Bereich auf. Zudem ist mindestens eine farbgebende optische Interferenzschicht an der ersten Scheibe angeordnet. Durch die mindestens eine optische Interferenzschicht wird die erste Scheibe zu einer farbgebenden ersten Scheibe.

Die mindestens eine optische Interferenzschicht dient zur Reflexion von Licht innerhalb eines vorgegebenen bzw. vorgebbaren Wellenlängenbereichs Die mindestens eine optische Interferenzschicht ist vorzugsweise unmittelbar (d.h. ohne weitere Zwischenschicht) auf einer Fläche der ersten Scheibe angeordnet.

Die mindestens eine optische Interferenzschicht kann ein- oder mehrlagig ausgebildet sein, d.h. eine oder mehrere lichtbrechende Lagen (Brechungsschichten) aufweisen. Die optische Interferenzschicht dient zur Erzeugung der Farbe der ersten Scheibe und somit des Fassadenelements, wobei die optische Interferenzschicht so ausgebildet ist, dass eine konstruktive bzw. destruktive Interferenz von Licht, das an den verschiedenen Grenzflächen der optischen Interferenzschicht reflektiert wird, möglich ist. Die Farbe des Fassadenelements ergibt sich aus der Interferenz des an den Grenzflächen der optischen Interferenzschicht reflektierten Lichts. Bei Beleuchtung mit (Weiß-)Licht, insbesondere Sonnenlicht, wirkt die optische Interferenzschicht als Farbfilter zur Erzeugung einer homogenen Farbe. Vorzugsweise erstreckt sich der strukturierte Bereich über die komplette erste Scheibe, d.h. über die komplette Fläche (Vorderfläche und/oder Rückfläche) der ersten Scheibe, so dass das komplette Fassadenelement eine homogene Farbe hat. Das Fassadenelement kann auch mehrere Fassadenelementabschnitte mit jeweils homogener Farbe aufweisen. Die Farben der Fassadenelementabschnitte können gleich oder voneinander verschieden sein.

Der mindestens eine strukturierte Bereich weist senkrecht zur Ebene der farbgebenden ersten Scheibe ein Höhenprofil mit Bergen (Erhebungen) und Tälern (Einsenkungen) auf, wobei ein mittlerer Höhenunterschied zwischen den Bergen und Tälern mindestens 2 µm und vorzugsweise, jedoch nicht zwingend, maximal 20%, bevorzugt maximal 10%, stärker bevorzugt maximal 5%, einer Dicke der transparenten oder semi-transparenten ersten Scheibe beträgt. Ferner setzen sich mindestens 50%, bevorzugt mindestens 80%, stärker bevorzugt mindestens 90%, des strukturierten Bereichs der Fläche (Vorder- und/oder Rückfläche) aus unterschiedlich geneigten Segmenten bzw. Facetten zusammen. Die Segmente sind Abschnitte der zur äußeren Umgebung gerichteten Fläche der farbgebenden ersten Scheibe und jeweils als plane Flächen ausgebildet, die zur Ebene der farbgebenden ersten Scheibe geneigt sind. Hierbei haben, bezogen auf die Ebene der farbgebenden ersten Scheibe, mindestens 20% der Segmente einen Neigungswinkel im Bereich von größer als 0° bis maximal 15° und mindestens 30% der Segmente einen Neigungswinkel im Bereich von größer als 15° bis maximal 45°. Vorteilhaft, jedoch nicht zwingend, haben weniger als 30% der Segmente einen Neigungswinkel von größer als 45°. Die Strukturen sind bevorzugt nicht periodisch und anisotrop. Für spezielle optische Effekte können jedoch auch periodische Strukturen und aniostrope Strukturen zur Anwendung kommen.

Ferner sind die Segmente jeweils eben (plan) und haben eine Segmentfläche von mindestens 1 µm². Weiterhin gilt, dass in mindestens einer Zone (d.h. Teilbereich) des strukturierten Bereichs die Segmente jeweils eine mittlere Rauigkeit von weniger als 15%, bevorzugt weniger als 10%, stärker bevorzugt weniger als 5%, einer Schichtdicke der optischen Interferenzschicht, welche auf den strukturierten Bereich aufgebracht ist, haben. Falls die optische Interferenzschicht aus mehreren Brechungsschichten besteht, haben die Segmente der mindestens einen Zone jeweils eine mittlere Rauigkeit von weniger als 15% einer Schichtdicke der Brechungsschicht mit geringster Schichtdicke. Die Zone, in der die Segmente jeweils eine mittlere Rauigkeit von weniger als 15% der Schichtdicke der optischen Interferenzschicht haben, kann dem strukturierten Bereich entsprechen, d.h. Zone und strukturierter Bereich sind dann identisch. Der strukturierte Bereich kann beispielsweise durch Ätzen, Sandstrahlen oder Walzen der ersten Scheibe hergestellt werden.

Demnach weist der mindestens eine strukturierte Bereich der farbgebenden ersten Scheibe des Fassadenelements eine Vielzahl von ebenen (planen) Segmenten auf. Im Sinne vorliegender Erfindung können ebene (plane) Segmente durch nicht-gekrümmte Flächen gebildet werden. Möglich ist aber auch, dass ebene (plane) Segmente durch geringfügig gekrümmte Flächen gebildet werden. Ein Segment ist im Sinne vorliegender Erfindung dann geringfügig gekrümmt, wenn für jeden Punkt des Segments gilt: wenn an einem Punkt des Segments eine (gedachte) Tangentialebene mit einer Fläche von 1 µm² konstruiert wird, beträgt der Abstand zwischen der Fläche des Segments und der Tangentialebene, bezogen auf die Normalenrichtung zur Tangentialebene, weniger als 50 nm.

Im Sinne vorliegender Erfindung bezeichnet der Begriff "Strukturierung" bzw. "strukturierter Bereich" im Zusammenhang mit dem Fassadenelement einen Bereich der Vorderfläche oder Rückfläche der farbgebenden ersten Scheibe, in dem die vorstehend beschriebenen Merkmale in Kombination vorliegen.

Durch die Merkmale des strukturierten Bereichs kann in vorteilhafter Weise erreicht werden, dass bei Beleuchtung der farbgebenden ersten Scheibe mit Licht auch bei einer Beobachtung außerhalb des Glanzwinkels (Einfallswinkel des auftreffenden Lichts entspricht Ausfallswinkel des reflektierten Lichts, bezogen auf die Ebene der farbgebenden ersten Scheibe) Licht mit relativ hoher Intensität zurückgeworfen wird. Ursache hierfür sind die verschieden geneigten Segmente, die in ausreichender Anzahl, geeigneter Größe und geeigneten Neigungswinkeln vorhanden sind, um eine hohe Intensität des reflektierten Lichts auch bei einer Beobachtung außerhalb des Glanzwinkels zu ermöglichen. Es gibt stets hinreichend viele geneigte Segmente, die bei Strukturierung außen durch Brechung an den Segmenten und bei Strukturierung innen durch Reflexion an den Segmenten genügend Intensität in Richtungen außerhalb des Glanzwinkels der farbgebenden ersten Scheibe streuen.

Wie hier und im Weiteren verwendet, bezieht sich der Begriff "Glanzwinkel" auf die Normale zur Ebene der farbgebenden ersten Scheibe, im Unterschied zum "lokalen Glanzwinkel", der sich auf die Normale zur Ebene eines Segments bezieht. Glanzwinkel und lokaler Glanzwinkel können gleich sein (Segment ist parallel zur Ebene der farbgebenden ersten Scheibe), sind jedoch in aller Regel verschieden (Segment ist geneigt zur Ebene der farbgebenden ersten Scheibe).

Im Ergebnis kann erreicht werden, dass die Intensität des nicht im Glanzwinkel reflektierten (d.h. gestreuten) Lichts relativ hoch ist, welches im Vergleich zu einer reflektierenden Oberfläche ohne einen solchen strukturierten Bereich, eine nur geringe Winkelabhängigkeit in Bezug auf die Einstrahl- und Beobachtungsrichtung hat. Mittels der optischen Interferenzschicht kann das außerhalb des Glanzwinkels reflektierte Licht, abhängig von Brechungsindex und Schichtdicke der optischen Interferenzschicht, einer Farbselektion unterzogen werden, so dass die Oberfläche der farbgebenden ersten Scheibe eine homogene Farbe mit relativ geringer Winkelabhängigkeit hat. Die Interferenzschicht wirkt als Filter mit möglichst schmalbandiger Reflexion und einer breitbandigen Transmission.

In dieser Hinsicht vorteilhaft weist der strukturierte Bereich ein Höhenprofil auf, bei dem ein mittlerer Höhenunterschied zwischen den Bergen und Tälern mindestens 2 µm, bevorzugt mindestens 10 µm und besonders bevorzugt mindestens 15 µm beträgt. Ein derart strukturierter Bereich kann durch Ätzen der ersten Scheibe (z.B. aus Glas) erzeugt werden. In dieser Hinsicht gleichermaßen vorteilhaft weist der strukturierte Bereich ein Höhenprofil auf, bei dem ein mittlerer Höhenunterschied zwischen den Bergen und Tälern mindestens 50 µm, bevorzugt mindestens 100 µm beträgt. Ein derart strukturierter Bereich kann durch Walzen der farbgebenden ersten Scheibe (z.B. aus Glas) erzeugt werden. Dementsprechend erstreckt sich die Erfindung vorteilhaft auf ein Fassadenelement, dessen mindestens ein strukturierter Bereich der farbgebenden ersten Scheibe durch Ätzen oder Walzen hergestellt ist, wodurch die genannten Höhenprofile herstellbar sind.

Die Strukturen können aber auch durch das Aufbringen einer transparenten und strukturierten Schicht auf die farbgebende erste Scheibe erzeugt werden. Die Schicht muss dabei einen gleichen (oder zumindest sehr ähnlichen) Brechungsindex haben wie die erste Scheibe. Erfindungsgemäß soll das Strukturieren einer Oberfläche der farbgebenden ersten Scheibe auch das Aufbringen einer solchen transparenten und strukturierten Schicht umfassen.

Die genannten Eigenschaften des strukturierten Bereichs der farbgebenden ersten Scheibe können durch herkömmliche Messgeräte, wie ein Mikroskop, insbesondere ein Konfokalmikroskop oder ein Nadelprofilometer, gemessen werden.

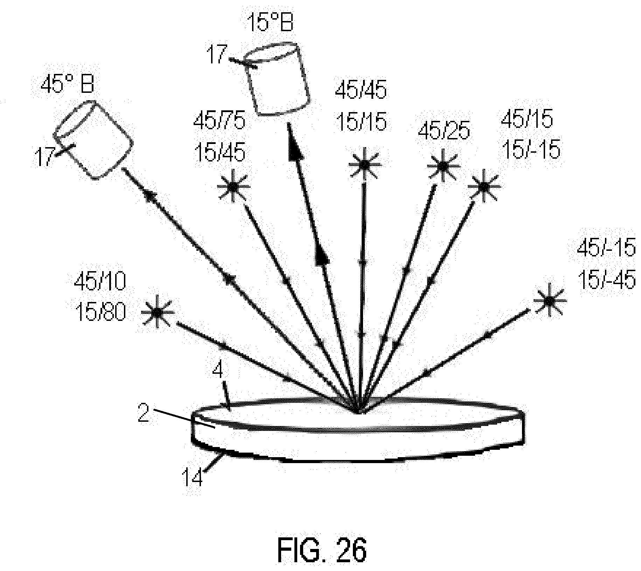

Vorzugsweise wird durch den mindestens einen strukturierten Bereich der (unbeschichteten) ersten Scheibe des erfindungsgemäßen Fassadenelements erreicht, dass bei Beobachtungswinkeln von 45° und 15° (jeweils bezogen auf die Ebene der ersten Scheibe) und einem Einfallswinkel, der um 45° vom jeweiligen Glanzwinkel abweicht (in beiden Richtungen), eine Helligkeit L des reflektierten Lichts von mindestens 10 auftritt. Vorzugsweise tritt eine Helligkeit L des reflektierten Lichts von mindestens 15 und stärker bevorzugt mindestens 20 auf. Bei dieser Messung ist auf der von der zu charakterisierenden Seite abgewandten Seite (d.h. Rückfläche) der (unbeschichteten) ersten Scheibe eine schwarze Abdeckung angebracht. Für die Messung wird ein D65-Strahler verwendet und mit einem im Handel verfügbaren Mehrwinkel-Farbmessgerät die Helligkeit L gemessen (10° Öffnungswinkel). Der Messaufbau wird weiter unten in Verbindung mit Figur 26 näher erläutert. In diesem Zusammenhang wird auf die europäische Norm EN ISO 11664-4 in vollem Umfang Bezug genommen.

In dem erfindungsgemäßen Fassadenelement dient die erste Scheibe zur Farbgebung des Fassadenelements, wohingegen die zweite Scheibe zur mechanischen Unterstützung (Verstärkung) des Fassadenelements dient. Bei einer vorteilhaften Ausgestaltung des Fassadenelements ist die mechanisch unterstützende zweite Scheibe dicker und somit mechanisch stärker als die farbgebende erste Scheibe, so dass beide Scheiben im Hinblick auf deren Funktion optimiert werden können. Alternativ ist es jedoch auch möglich, dass die farbgebende erste Scheibe dicker ist als die mechanisch unterstützende zweite Scheibe. Dies kann insbesondere vorteilhaft sein, wenn für eine gewünschte mechanische Stabilität des Fassadenelements eine weitere (mechanisch unterstützende) Scheibe mit relativ geringer Scheibendicke ausreicht.

Bei einer Ausgestaltung des erfindungsgemäßen Fassadenelements ist die farbgebende erste Scheibe lichteinfallseitig der Zwischenschicht angeordnet, d.h. die erste Scheibe bildet die vorderseitige Deckscheibe des Fassadenelements. Alternativ ist es jedoch auch möglich, dass die mechanisch unterstützende zweite Scheibe lichteinfallseitig der Zwischenschicht angeordnet ist, d.h. die zweite Scheibe bildet die vorderseitige Deckscheibe des Fassadenelements. Im letztgenannten Fall passiert das Licht die mechanisch unterstützende zweite Scheibe bis es auf die farbgebende erste Scheibe trifft. Die Farbe des Fassadenelements ergibt sich durch die bei Beleuchtung mit Weißlicht (z.B. Sonnenlicht) von der mindestens einen optischen Interferenzschicht selektierten Farbe, wobei die selektierte Farbe mit der Hintergrundfarbe einer flächigen Struktur (z.B. Wand), an welcher das Fassadenelement angebracht ist, kombiniert wird. Der Gesamteindruck ergibt sich somit aus selektierter Farbe und Hintergrundfarbe.

Grundsätzlich ist es möglich, dass das Fassadenelement ohne ein zur Farbgebung beitragendes Rückseitenelement verwendet wird. In der Praxis sollte dann die Hintergrundfarbe der flächigen Struktur, an welcher das Fassadenelement angebracht ist, berücksichtigt werden.

Um eine vom Hintergrund unabhängige Farbgebung zu erzielen, weist das Fassadenelement an seiner Rückseite mindestens ein flächiges Rückseitenelement auf. Vorzugsweise ist das mindestens eine flächige Rückseitenelement opak oder semi-transparent. Das mindestens eine flächige Rückseitenelement ist an der Rückseite des Fassadenelements angeordnet, d.h. in Richtung des Lichteinfalls hinter dem festen Verbund aus farbgebender erster Scheibe und mechanisch unterstützender zweiter Scheibe.

Das mindestens eine Rückseitenelement trägt zur Farbgebung des Fassadenelements bei. Zu diesem Zweck ist das Rückseitenelement beispielsweise unbunt, dunkel und matt ausgebildet. Möglich ist auch, dass das Rückseitenelement farbig ist, um in Kombination mit der mindestens einen farbgebenden optischen Interferenzschicht, welche an der ersten Scheibe angeordnet ist, dem Fassadenelement einen bestimmten (vorgegebenen bzw. vorgebbaren) Farbeindruck zu vermitteln. Ist das Rückseitenelement fotovoltaisch aktiv und weist CIGS-Dünnschichtsolarzellen auf, tragen diese zur Gesamtfarbe bei. Die CIGS-Dünnschichtsolarzellen haben typischer Weise eine bläulich-schwarze Färbung.

Wie bereits ausgeführt, verfügt die erste Scheibe über eine der äußeren Umgebung zugewandte Vorderfläche und gegenüberliegend hierzu eine Rückfläche. Analog hierzu weist die zweite Scheibe eine der äußeren Umgebung (Lichteinfallseite) zugewandte Vorderfläche und gegenüberliegend zur Vorderfläche eine Rückfläche auf. Die Vorderfläche einer jeweiligen Scheibe ist im verbauten Zustand des Fassadenelements in der Fassade der äußeren Umgebung zugewandt.

Das mindestens eine flächige Rückseitenelement weist eine Kontaktfläche auf, die mit der Rückfläche der rückseitigen Scheibe (erste oder zweite Scheibe), d.h. der Rückfläche jener Scheibe, die auf der vom Lichteinfall abgewandten Seite der Zwischenschicht angeordnet ist, fest verbunden ist.

Das mindestens eine flächige Rückseitenelement bedeckt beispielsweise mindestens 70%, mindestens 90%, oder mindestens 99% der Rückfläche der rückseitigen Scheibe. Insbesondere bedeckt das flächige Rückseitenelement die Rückfläche der rückseitigen Scheibe vollflächig (zu 100%, d.h. vollständige Überdeckung). Möglich ist jedoch auch, dass das mindestens eine flächige Rückseitenelement weniger als 70%, insbesondere weniger als 50% der Rückfläche der rückseitigen Scheibe bedeckt.

Das flächige Rückseitenelement des Fassadenelements kann fotovoltaisch aktiv oder passiv ausgebildet sein.

Gemäß einer bevorzugten Ausgestaltung des erfindungsgemäßen Fassadenelements ist das mindestens eine flächige Rückseitenelement fotovoltaisch aktiv ausgebildet, d.h. zur Energieerzeugung aus Sonnenlicht geeignet und bestimmt. Das farbige Fassadenelement kann somit in vorteilhafter Weise zur fotovoltaischen Energieerzeugung eingesetzt werden.

Bevorzugt handelt es sich bei dem mindestens einen fotovoltaisch aktiven Rückseitenelement um ein Trägersubstrat (Scheibe) mit hierauf aufgebrachten serienverschalteten Solarzellen, wobei das Trägersubstrat vorzugsweise direkt, d.h. ohne zwischenliegende Scheibe, mit der rückseitigen Scheibe (erste oder zweite Scheibe) des Verbunds aus erster und zweiter Scheibe durch eine weitere Zwischenschicht fest verbunden ist (z.B. durch Lamination). Die rückseitige Scheibe bildet mit dem Trägersubstrat somit einen weiteren Verbund aus zwei Scheiben aus. Insgesamt ergibt sich eine Verbundscheibenstruktur, bei der drei Scheiben durch Lamination fest miteinander verbunden sind (erste Scheibe, zweite Scheibe, Trägersubstrat). Die Solarzellen sind durch den Verbund aus farbgebender erster und mechanisch unterstützender zweiter Scheibe gut gegen äußere Witterungseinflüsse geschützt.

Vorteilhaft kann es sein, wenn das flächige Rückseitenelement, bezogen auf die Scheibenebene, kleiner ist als die frontseitige Scheibe. Die Abmessungen des flächigen Rückseitenelements entlang jeder Richtung der frontseitigen Scheibe sind somit kleiner als die Abmessungen der frontseitigen Scheibe. Durch diese Maßnahme ist das flächige Rückseitenelement, vor allem, wenn es Solarzellen aufweist, besonders gut gegen äußere Einflüsse geschützt.

Das fotovoltaisch aktive Rückseitenelement ist mit elektrisch in Serie verschalteten Solarzellen zur fotovoltaischen Energieerzeugung versehen. Grundsätzlich kann es sich um jede Art von Solarzellen handeln, insbesondere um Silizium-basierte Solarzellen auf Wafer-Basis (Solarzellen auf Trägersubstrat in Superstratkonfiguration) oder um Dünnschichtsolarzellen, die in monolithisch integrierter Form serienverschaltet sind (Solarzellen auf Trägersubstrat in Substratkonfiguration). Vorzugsweise handelt es sich um Dünnschichtsolarzellen, die in monolithisch integrierter Form serienverschaltet sind.

Durch Laminieren mit der rückseitigen Scheibe des Verbunds aus erster und zweiter Scheibe wird aus dem Trägersubtrat mit aufgebrachten Solarzellen und der rückseitigen Scheibe ein Dünnschichtsolarmodul mit Verbundscheibenstruktur erzeugt, wobei die rückseitige Scheibe sowohl mit der frontseitigen Scheibe als auch mit dem Trägersubstrat durch eine jeweilige Zwischenschicht fest verbunden ist.

Möglich ist jedoch auch, dass ein vollständiges Solarmodul, welches zwei durch eine Zwischenschicht fest miteinander verbundene Scheiben umfasst (z.B. Trägersubstrat mit Solarzellen, insbesondere Dünnschicht-Solarzellen, und Deckplatte) mit einer einzelnen Scheibe (erste Scheibe oder zweite Scheibe) fest verbunden wird. Im Ergebnis entsteht auch hier eine Verbundscheibenstruktur mit drei Scheiben, die durch zwei Zwischenschichten fest miteinander verbunden sind. Vorteilhaft kann auf diese Weise eine vorgefertigtes Solarmodul verwendet werden. Das vorgefertigte Solarmodul kann wahlweise die mechanisch unterstützende zweite Scheibe oder die farbgebende erste Scheibe aufweisen, wobei das Solarmodul dann mit der jeweils anderen Scheibe (farbgebende erste Scheibe oder mechanisch unterstützende zweite Scheibe) fest verbunden wird. Jede Zwischenschicht ist vorzugsweise eine thermoplastische oder vernetzende Polymer-Zwischenschicht (z.B. PVB oder EVA), welche die beiden Scheiben verklebt. Eine Verklebung ist auch durch ein transparentes Silikon oder Gießharz möglich.

Das fotovoltaisch aktive Rückseitenelement weist vorzugsweise Dünnschichtsolarzellen in Substratkonfiguration auf, bei der der Schichtenaufbau zur Herstellung der Solarzellen auf einer der Lichteintrittsseite zugewandten Oberfläche des Trägersubstrats aufgebracht ist. In Einklang mit der üblichen Verwendung bezieht sich der Begriff "Dünnschichtsolarzellen" auf einen Schichtenaufbau mit einer geringen Dicke von beispielsweise einigen Mikrometern, so dass ein Trägersubstrat für eine ausreichende mechanische Festigkeit benötigt wird. Das Trägersubstrat kann beispielsweise aus anorganischem Glas, Stahl oder Kunststoff bestehen und kann in Abhängigkeit von der jeweiligen Schichtdicke und den spezifischen Materialeigenschaften als starre Platte oder biegsame Folie ausgestaltet sein. Vorzugsweise besteht das Trägersubstrat aus Glas.

Bei Dünnschichtsolarzellen umfasst der Schichtenaufbau in an sich bekannter Weise eine Rückelektrodenschicht, eine Frontelektrodenschicht, und eine zwischen Rück- und Frontelektrodenschicht angeordnete, fotovoltaisch aktive Absorberschicht. Die Frontelektrodenschicht ist optisch transparent, da ein Durchtritt von Licht zum Schichtenaufbau ermöglicht sein muss. Die optisch transparente Frontelektrodenschicht umfasst oder besteht typischer Weise aus einem dotierten Metalloxid (TCO = Transparent Conductive Oxide), beispielsweise n-leitendes, insbesondere Aluminium-dotiertes, Zinkoxid (AZO).

Vorzugsweise umfasst oder besteht die fotovoltaisch aktive Absorberschicht aus einem Chalkopyrit-Halbleiter, bei dem es sich vorteilhaft um einen ternären I-III-VI-Verbindungshalbleiter aus der Gruppe Kupfer-Indium/Gallium-Disulfid/Diselenid (Cu(In,Ga)(S,Se)₂) handelt. In vorstehender Formel können Indium und Gallium jeweils allein oder in Kombination vorliegen. Entsprechendes gilt für Schwefel und Selen, die jeweils allein oder in Kombination vorliegen können. Als Material für die Absorberschicht eignet sich in besonderer Weise CIS (Kupferindiumdiselenid/-disulfid) oder CIGS (Kupferindiumgalliumdiselenid, Kupferindiumgalliumdisulfid, Kupferindiumgalliumdisulfoselenid). Die Absorberschicht weist typischer Weise eine Dotierung von einem ersten Leitungstyp (Ladungsträgertyp) und die Frontelektrode eine Dotierung vom entgegengesetzten Leitungstyp auf. In aller Regel ist die Absorberschicht p-leitend (p-dotiert), verfügt also über einen Überschuss von Defektelektronen (Löcher) und die Frontelektrodenschicht ist n-leitend (n-dotiert), so dass freie Elektronen in Überschuss vorhanden sind. Zwischen Absorberschicht und Frontelektrodenschicht ist typischer Weise eine Pufferschicht angeordnet. Dies gilt insbesondere für Absorberschichten auf Basis von Cu(In,Ga)(S,Se)₂, bei denen in aller Regel eine Pufferschicht zwischen einer p-leitenden Cu(In,Ga)(S,Se)₂-Absorberschicht und einer n-leitenden Frontelektrode benötigt wird. Nach derzeitiger Erkenntnis ermöglicht die Pufferschicht eine elektronische Anpassung zwischen Absorber und Frontelektrode. Sie bietet außerdem einen Schutz vor Sputterschäden in einem nachfolgenden Prozeßschritt der Abscheidung der Frontelektrode beispielsweise durch DC-Magnetron-Sputtern. Durch die Abfolge aus n-leitender Frontelektrodenschicht, Pufferschicht und p-leitender Absorberschicht wird ein p-n-Heteroübergang gebildet, das heißt ein Übergang zwischen Schichten vom entgegengesetzten Leitungstyp. Die fotovoltaisch aktive Absorberschicht kann beispielsweise auch aus Cadmiumtellerid (CdTe) oder amorphem und/oder mikrokristallinem Silizium bestehen.

Im Schichtenaufbau sind durch Strukturierungszonen serienverschaltete Solarzellen ausgebildet. So ist mindestens die Rückelektrodenschicht durch erste Strukturierungslinien (P1-Linien) in vollständig voneinander getrennte Abschnitte unterteilt, welche die Rückelektroden der Solarzellen bilden. Ferner ist mindestens die Absorberschicht durch zweite Strukturierungslinien (P2-Linien) in vollständig voneinander getrennte Abschnitte unterteilt, welche die Absorber der Solarzellen bilden, und mindestens die Frontelektrodenschicht ist durch dritte Strukturierungslinien (P3-Linien) in vollständig voneinander getrennte Abschnitte unterteilt, welche die Frontelektroden der Solarzellen bilden. Benachbarte Solarzellen sind über elektrisch leitfähiges Material in den zweiten Strukturierungslinien in Serienverschaltung elektrisch miteinander verbunden, wobei die Frontelektrode einer Solarzelle mit der Rückelektrode der benachbarten Solarzelle elektrisch verbunden ist und mit dieser typischer Weise, jedoch nicht zwingend, direkten Berührungskontakt hat. Jede Strukturierungszone umfasst eine unmittelbare Abfolge der drei Strukturierungslinien P1-P2-P3, jeweils in dieser Reihenfolge.

Dünnschichtmodule auf Basis von amorphem und/oder mikrokristallinem Silizium und auf Basis von CdTe sind meist in Superstratkonfiguration aufgebaut. Die Dünnschichtsolarzellen sind also auf der lichteintrittsseitigen Oberfläche des Glases angeordnet. Auf der Rückseite befindet sich meist ein zweites Glas zur klimastabilen Verkapselung. In diesem Fall kann das transparente lichteintrittsseitige Trägerglas auch die Rolle der mechanisch unterstützenden Scheibe einnehmen. Durch Lamination mit einer farbgebenden Scheibe entsteht ein erfindungsgemäßes farbiges Verbundglasmodul.

In Einklang mit der gängigen Verwendung bezieht sich der Begriff "Solarzelle" bei Dünnschichtsolarmodulen auf einen Bereich des Schichtenaufbaus, der eine Frontelektrode, einen fotovoltaisch aktiven Absorber und eine Rückelektrode aufweist und von zwei einander unmittelbar benachbarten Strukturierungszonen begrenzt wird. Jede Solarzelle weist eine optisch aktive Zone auf, die, stapelförmig übereinander angeordnet, eine Rückelektrode, einen Absorber und eine Frontelektrode umfasst und zur fotoelektrischen Konversion von Licht in elektrischen Strom fähig ist.

Gemäß einer Ausgestaltung des erfindungsgemäßen Fassadenelements ist in Richtung des Lichteinfalls, hinter der letzten Interferenzschicht (siehe weiter unten), eine das mindestens eine Rückseitenelement teilweise überdeckende Maskierungsschicht angeordnet, welche fotovoltaisch inaktive Bereiche des Rückseitenelements (Anschlüsse, Busbars, Anschlussdosen usw.) überdeckt. Demnach sind nur die optisch aktiven Bereiche der Solarzellen von der äußeren Umgebung her sichtbar, wodurch die äußere Erscheinung des Fassadenelements weiter verbessert wird.

Das flächige Rückseitenelement ist mit der rückseitigen Scheibe fest verbunden. Das flächige Rückseitenelement kann selbst eine Farbe aufweisen, wobei die Farbe des Rückseitenelements die Gesamtfarbe des Fassadenelements beeinflusst.

Gemäß einer Ausgestaltung des erfindungsgemäßen Fassadenelements ist das flächige Rückseitenelement fotovoltaisch passiv, d.h. nicht zur Energieerzeugung durch Sonnenlicht bestimmt und geeignet.

Das fotovoltaisch passive Rückseitenelement ist beispielsweise in Form einer Beschichtung, insbesondere einer opaken Beschichtung, der Rückfläche der rückseitigen Scheibe (erste oder zweite Scheibe) ausgebildet. Gleichermaßen kann das Rückseitenelement beispielsweise in Form einer mit der Rückfläche der rückseitigen Scheibe (erste oder zweite Scheibe) fest verbundenen Folie, insbesondere einer opaken Folie, oder eines starren Körpers (keine Beschichtung), insbesondere eines opaken starren Körpers, beispielsweise in Plattenform, ausgebildet sein. Der starre Körper kann ein tragender oder nicht-tragender Körper sein und kann als tragender Körper insbesondere eine Trägerplatte sein. Die Verbindung einer Folie oder eines Körpers mit der rückseitigen Scheibe (erste oder zweite Scheibe) kann durch ein transparentes Klebemittel, insbesondere eine transparente Klebefolie, erfolgen.

Insbesondere kann die Farbe des fotovoltaisch passiven flächigen Rückseitenelements in Entsprechung zum opaken Hintergrund farbiger Solarmodule gewählt sein, d.h. das Rückseitenelement kann eine Farbe aufweisen, die den optisch aktiven Solarzellen entspricht. Vorzugsweise ist das fotovoltaisch passive flächige Rückseitenelement unbunt, dunkel und matt. Dann lassen sich der Farbeindruck und die Winkelabhängigkeit des Fassadenelements besonders gut mit den entsprechend hergestellten farbigen Modulen auf Basis von Dünnschichtmodulen anpassen. Diese Eigenschaften lassen sich wie folgt beschreiben:
- ein L-Wert von maximal 50, bevorzugt kleiner 45 oder kleiner 40;
- ein Chroma c = (a²+b²)^{1/2} von maximal 5, bevorzugt kleiner 2 oder stärker bevorzugt kleiner 1,5.

Zur Vermeidung von Glanz kann zusätzlich folgende Anforderung hinzugenommen werden:
- ein Reflexions-Haze von mindestens 90%, wobei Reflexionshaze der Anteil des diffus reflektierten Lichts an dem insgesamt reflektierten Licht ist.

Im Weiteren werden verschiedene Ausgestaltungen der farbgebenden ersten Scheibe des erfindungsgemäßen Fassadenelements beschrieben.

Gemäß einer Ausgestaltung (zur leichteren Bezugnahme als "Typ I" bezeichnet) des Fassadenelements weist die Vorderfläche der farbgebenden ersten Scheibe mindestens einen strukturierten Bereich auf, auf dem eine farbgebende optische Interferenzschicht zur Reflexion von Licht innerhalb eines vorgegebenen bzw. vorgebbaren Wellenlängenbereichs angeordnet ist. Die optische Interferenzschicht ist vorzugsweise unmittelbar (d.h. ohne weitere Zwischenschicht) auf der Vorderfläche der ersten Scheibe angeordnet.

Bei vorstehender Ausgestaltung vom Typ I kann es vorteilhaft sein, wenn die Rückfläche der farbgebenden ersten Scheibe keinen strukturierten Bereich und keine optische Interferenzschicht aufweist. Die Rückfläche ist dann vorzugsweise glatt (im Rahmen von Produktionsungenauigkeiten).

Bei vorstehender Ausgestaltung vom Typ I kann es weiterhin vorteilhaft sein, wenn die Rückfläche der farbgebenden ersten Scheibe keinen strukturierten Bereich aufweist, wobei auf der Rückfläche der farbgebenden ersten Scheibe eine weitere optische Interferenzschicht zur Reflexion von Licht innerhalb eines vorgegebenen Wellenlängenbereichs angeordnet ist. Die Rückfläche ist vorzugsweise glatt (im Rahmen von Produktionsungenauigkeiten). Die beiden optischen Interferenzschichten können gleich oder voneinander verschieden sein. Insbesondere können die beiden optischen Interferenzschichten zur Reflexion von Licht innerhalb eines selben Wellenlängenbereichs ausgebildet sein. Möglich ist jedoch auch, dass die beiden optischen Interferenzschichten zur Reflexion von Licht innerhalb verschiedener oder nur teilweise überlappender Wellenlängenbereiche ausgebildet sind. Die Schichtdicken und Brechungsindizes der beiden optischen Interferenzschichten können gleich oder voneinander verschieden sein. Durch diese Maßnahme kann die Farbe des Fassadenelements noch besser definiert werden. Zudem können Mischfarben generiert werden.

Bei vorstehender Ausgestaltung vom Typ I kann es weiterhin vorteilhaft sein, wenn die Rückfläche mindestens einen strukturierten Bereich aufweist, auf dem eine optische Interferenzschicht zur Reflexion von Licht innerhalb eines vorgegebenen Wellenlängenbereichs angeordnet ist. Der strukturierte Bereich der Rückfläche und der strukturierte Bereich der Vorderfläche können gleich oder voneinander verschieden sein. Die Schichtdicken und Brechungsindizes der beiden optischen Interferenzschichten können gleich oder voneinander verschieden sein. Auch durch diese Maßnahmen kann die Farbe des Fassadenelements noch besser definiert werden. Zudem können Mischfarben generiert werden.

Bei der Ausgestaltung des Fassadenelements vom Typ I entsteht bereits beim Auftreffen des Lichts auf die strukturierte Vorderfläche der ersten Scheibe mit Interferenzschicht durch Reflexion, Transmission, partieller Absorption und Interferenz eine Farbe mit hoher Intensität und geringer Winkelabhängigkeit auch außerhalb des Glanzwinkels. Die zusätzliche Interferenzschicht und/oder Strukturierung auf der Rückfläche der ersten Scheibe können diese Wirkung noch verstärken.

Gemäß einer weiteren Ausgestaltung (zur leichteren Bezugnahme als "Typ II" bezeichnet) des Fassadenelements ist auf der Rückfläche der farbgebenden ersten Scheibe eine farbgebende optische Interferenzschicht zur Reflexion von Licht innerhalb eines vorgegebenen bzw. vorgebbaren Wellenlängenbereichs angeordnet. Die optische Interferenzschicht ist vorzugsweise unmittelbar (ohne weitere Zwischenschicht) auf der Rückfläche der farbgebenden ersten Scheibe angeordnet. Zudem weist die Rückfläche und/oder die Vorderfläche der farbgebenden ersten Scheibe jeweils mindestens einen strukturierten Bereich auf, mit der Maßgabe, dass entweder die Vorderfläche mindestens einen strukturierten Bereich aufweist oder auf der Vorderfläche eine weitere optische Interferenzschicht zur Reflexion von Licht innerhalb eines vorgegebenen bzw. vorgebbaren Wellenlängenbereichs angeordnet ist. Die optische Interferenzschicht ist vorzugsweise unmittelbar (ohne weitere Zwischenschicht) auf der Vorderfläche der farbgebenden ersten Scheibe angeordnet. Dies bedeutet, dass keine optische Interferenzschicht auf der Vorderfläche angeordnet ist, wenn die Vorderfläche mindestens einen strukturierten Bereich aufweist.

Das auftreffende Licht muss demnach mindestens einmal die erste Scheibe passieren und an der innenliegenden Interferenzschicht reflektiert werden, um die gewünschte Farbigkeit mit der verbesserten Winkelstabilität zu erreichen. Durch die innen und/oder außen strukturierte Oberfläche der farbgebenden ersten Scheibe wird Licht mit einer hohen Intensität und geringer Winkelabhängigkeit auch außerhalb des Glanzwinkels reflektiert, da die innen liegende Interferenzschicht eine Grenzfläche mit höherem Brechungsindex darstellt. Bei außenliegender Strukturierung wird das Licht bereits an der Grenzfläche Luft und Scheibe gebrochen und trifft diffus gestreut aus verschiedensten Winkeln auf die innen liegende Interferenzschicht. Bei nur innen liegender Strukturierung findet die diffuse Streuung an dieser inneren Grenzfläche statt, da erfindungsgemäß viele Oberflächensegmente mit unterschiedlichen Neigungswinkeln zur Verfügung stehen. Zudem wird durch die farbgebende optische Interferenzschicht ein guter homogener Farbeindruck erreicht. Die Interferenzschicht wirkt somit als Filter mit möglichst schmalbandiger Reflexion und einer breitbandigen Transmission.

Bei vorstehender Ausgestaltung vom Typ II kann es vorteilhaft sein, wenn auf der Rückfläche der farbgebenden ersten Scheibe eine optische Interferenzschicht angeordnet ist, wobei die Rückfläche der farbgebenden ersten Scheibe keinen strukturierten Bereich aufweist und die Vorderfläche der farbgebenden ersten Scheibe mindestens einen strukturierten Bereich aufweist, wobei keine weitere optische Interferenzschicht auf der Vorderfläche der farbgebenden ersten Scheibe angeordnet ist. Die Rückfläche ist vorzugsweise glatt (im Rahmen der Produktionsungenauigkeiten). Für die Segmente des strukturierten Bereichs der Vorderfläche des Fassadenelements gibt es keine Bedingung für die Rauigkeit. Die strukturierte Vorderfläche kann auch eine größere mikroskopische Rauigkeit aufweisen. An dieser Grenzfläche findet nur Transmission, Brechung und Streuung, jedoch keine Interferenz statt. Bei dieser Ausgestaltung des erfindungsgemäßen Fassadenelements kann es vorteilhaft sein, wenn die Vorderfläche der farbgebenden ersten Scheibe mit einer (z.B. dünnen) Antireflexschicht beschichtet ist, deren optischer Brechungsindex kleiner ist als jener der farbgebenden ersten Scheibe. Hierdurch kann eine im Wesentlichen weiße Reflexion der farbgebenden ersten Scheibe (z.B. Glas) unterdrückt werden und der Sättigungsgrad der Farben steigt. Eine zusätzliche Schicht auf der Vorderfläche der farbgebenden ersten Scheibe kann aber auch den gleichen Brechungsindex wie die farbgebende erste Scheibe aufweisen. In diesem Fall dient die Schicht nur dem Schutz der farbgebenden ersten Scheibe vor Feuchte und anderen korrosiven Bestandteilen der Luft. Es hat sich gezeigt, dass durch Ätzen hergestellte satinierte Gläser empfindlicher gegenüber feuchter Hitze sind als plane oder gewalzte Gläser. Im Falle von geätztem Kalknatronglas kann die zusätzliche Schicht zum Beispiel eine dünne gesputterte Si02-Schicht sein.

Bei vorstehender Ausgestaltung vom Typ II kann es weiterhin vorteilhaft sein, wenn auf der Rückfläche der farbgebenden ersten Scheibe eine optische Interferenzschicht angeordnet ist, wobei die Rückfläche der farbgebenden ersten Scheibe mindestens einen strukturierten Bereich aufweist und die Vorderfläche mindestens einen strukturierten Bereich aufweist, wobei keine weitere optische Interferenzschicht auf der Vorderfläche der farbgebenden ersten Scheibe angeordnet ist. Der strukturierte Bereich der Rückfläche und der strukturierte Bereich der Vorderfläche der farbgebenden ersten Scheibe können gleich oder voneinander verschieden sein. Für die Segmente des strukturierten Bereichs der Vorderfläche gibt es keine Bedingung für die Rauigkeit. Die strukturierte Vorderfläche kann auch eine größere mikroskopische Rauigkeit aufweisen. An dieser Grenzfläche findet nur Transmission, Brechung und Streuung, jedoch keine Interferenz statt. Für die Segmente des strukturierten Bereichs der Rückfläche gilt die oben genannten Bedingung für die Rauigkeit, da eine optische Interferenzschicht auf dem strukturierten Bereich angeordnet ist. Wenn die Vorderfläche strukturiert ist und die Interferenzschicht auf der Rückfläche liegt, entsteht die Winkelstabilität daraus, dass das Licht beim Eintritt durch die strukturierte Vorderfläche an den unterschiedlich geneigten Segmenten gebrochen wird, in verschiedenen Winkeln auf die Interferenzschicht trifft und nach Interferenz, partieller Absorption und Reflexion ein weiteres Mal die strukturierte Vorderfläche beim Austritt aus der farbgebenden ersten Scheibe passiert und dabei wiederum durch Brechung seine Richtung ändert.

Bei vorstehender Ausgestaltung vom Typ II des Fassadenelements kann es weiterhin vorteilhaft sein, wenn auf der Rückfläche der farbgebenden ersten Scheibe eine optische Interferenzschicht angeordnet ist, wobei die Rückfläche der farbgebenden ersten Scheibe mindestens einen strukturierten Bereich aufweist und die Vorderfläche der farbgebenden ersten Scheibe keinen strukturierten Bereich aufweist, wobei keine weitere optische Interferenzschicht auf der Vorderfläche der farbgebenden ersten Scheibe angeordnet ist. Die Vorderfläche ist vorzugsweise glatt (im Rahmen von Produktionsungenauigkeiten). Für die Segmente des strukturierten Bereichs der Rückfläche gilt die oben genannten Bedingung für die Rauigkeit, da eine optische Interferenzschicht auf dem strukturierten Bereich angeordnet ist. Bei dieser Ausgestaltung des erfindungsgemäßen Fassadenelements kann es vorteilhaft sein, wenn die Vorderfläche der farbgebenden ersten Scheibe mit einer (z.B. dünnen) Antireflexschicht beschichtet ist, deren Brechungsindex kleiner ist als jener der farbgebenden ersten Scheibe. Hierdurch kann eine im Wesentlichen weiße Reflexion einer gläsernen farbgebenden ersten Scheibe unterdrückt werden und der Sättigungsgrad der Farben steigt.

Bei vorstehender Ausgestaltung vom Typ II kann es weiterhin vorteilhaft sein, wenn die Rückfläche der farbgebenden ersten Scheibe mindestens einen strukturierten Bereich aufweist und die Vorderfläche keinen strukturierten Bereich aufweist, wobei eine weitere optische Interferenzschicht auf der Vorderfläche der farbgebenden ersten Scheibe angeordnet ist. Die Vorderfläche ist vorzugsweise glatt (im Rahmen von Produktionsungenauigkeiten). Für die Segmente des strukturierten Bereichs der Rückfläche gilt die oben genannten Bedingung für die Rauigkeit, da eine optische Interferenzschicht auf dem strukturierten Bereich angeordnet ist. Die beiden optischen Interferenzschichten können gleich oder voneinander verschieden sein. Insbesondere können die beiden optischen Interferenzschichten zur Reflexion von Licht innerhalb eines selben Wellenlängenbereichs ausgebildet sein. Möglich ist jedoch auch, dass die beiden optischen Interferenzschichten zur Reflexion von Licht innerhalb verschiedener oder nur teilweise überlappender Wellenlängenbereiche ausgebildet sind. Die Interferenzschicht auf der glatten Außenseite kann auch eine farbneutrale Antireflexschicht sein, um den Weißanteil des insgesamt reflektierten Lichtes zu reduzieren. Die Farbe wird durch Reflexion an der strukturierten Innenseite mit der Interferenzschicht erzeugt. Die Interferenzschicht an der glatten Außenseite kann aber auch eine farbgebende Schicht sein, die die an der Innenseite generierte Farbe verstärkt oder eine weitere Farbkomponente in einem anderen Wellenlängenbereich dazu mischt.

In der Ausgestaltung des Fassadenelements vom Typ II muss das einfallende Licht demnach mindestens einmal die farbgebende erste Scheibe passieren und muss an der innenliegenden Interferenzschicht reflektiert werden, um nach Austritt aus der Vorderfläche der farbgebenden ersten Scheibe die gewünschte Farbigkeit mit der verbesserten Winkelstabilität zu erreichen.

In dem erfindungsgemäßen Fassadenelement wird durch die strukturierte erste Scheibe Licht mit einer hohen Intensität und geringer Winkelabhängigkeit auch außerhalb des Glanzwinkels reflektiert. Durch die mindestens eine optische Interferenzschicht, welche farbgebend wirkt, wird ein sehr homogener Farbeindruck erzeugt.

Bei einer vorteilhaften Ausgestaltung des erfindungsgemäßen Fassadenelements setzen sich mindestens 80%, besonders bevorzugt mindestens 90%, eines strukturierten Bereichs der Vorderfläche oder der Rückfläche (je nachdem welche Fläche strukturiert ist) der farbgebenden ersten Scheibe aus den zur Ebene der farbgebenden ersten Scheibe geneigten Segmenten zusammen. Durch die Vergrößerung der Anzahl der Segmente kann die Intensität des vom strukturierten Bereich der Oberfläche der farbgebenden ersten Scheibe auch außerhalb des Glanzwinkels reflektierten Lichts und dessen Winkelstabilität noch weiter gesteigert werden.

Bei einer vorteilhaften Ausgestaltung des erfindungsgemäßen Fassadenelements liegen die Neigungswinkel der (Oberflächen-)Segmente zwischen 0° und 45° zur Ebene der ersten Scheibe (Glasebene). Mindestens 50 %, besser 70 % der geneigten Segmente sollten einen Anstellwinkel von kleiner 25° haben. Die Verteilung der Anstellwinkel sollte im Winkelbereich von 0° - 35°, bevorzugt 0° - 25°, ein Häufigkeitsmaximum aufweisen, welches im Bereich von 5° - 20°, bevorzugt zwischen 10° und 15°, liegt. Weiterhin sollte der Anteil ungeneigter Flächen (Anstellwinkel = 0°) kleiner als 5 % an der gesamten Winkelverteilung sein.

Bei einer vorteilhaften Ausgestaltung des erfindungsgemäßen Fassadenelements ist das Aspektverhältnis von Breite (B) zu Höhe (H) der Strukturen (Segmente) mindestens B:H > 2:1 und B:H < 50:1, besser B:H > 3:1 und B:H < 10:1.

Falls relativ viele Facetten mit einem kleinen Neigungswinkel von weniger als 10° vorliegen, tritt (wie bei einer unstrukturierten Oberfläche) im Wesentlichen nur eine reflektierte Intensität bei einem Beobachtungswinkel nahe des Glanzwinkels auf, was erfindungsgemäß nicht erwünscht ist. Gemäß vorstehenden Bedingungen kann eine sehr hohe Intensität des reflektierten Lichts auch außerhalb des Glanzwinkels bei zugleich besonders geringer Winkelabhängigkeit der Intensität erreicht werden. Die Strukturen sind bevorzugt nicht-periodisch und anisotrop. Für spezielle optische Effekte können jedoch auch periodische Strukturen und/oder anisotrope Strukturen zur Anwendung kommen. Periodische und anisotrope Strukturen wie Pyramiden, tetragonale oder hexagonale Wabenstrukturen oder Halbkugeln lassen sich gut mit Walzen beim Glasziehen herstellen. Sie können zu attraktiven Glanz- und Farbeffekten verwendet werden. Wenn die Oberflächenstrukturen die oben genannten Bedingungen erfüllen, zeigen die Fassadenelemente wiederum eine deutlich verringerte Abnahme der Farbigkeit für Winkel außerhalb der Glanzwinkel, jedoch sind die Winkelabhängigkeiten dann anisotrop in Bezug auf die Orientierung in der Ebene der farbgebenden ersten Scheibe.

Die mindestens eine optische Interferenzschicht kann eine oder mehrere Brechungsschichten enthalten und insbesondere aus diesen bestehen. Eine Brechungsschicht besteht aus einem selben Material (mit gleicher Zusammensetzung) und weist insbesondere über die Schichtdicke hinweg einen homogenen (gleichen) Brechungsindex auf. Enthält die optische Interferenzschicht mehrere Brechungsschichten, bestehen mindestens zwei Brechungsschichten aus einem voneinander verschiedenen Material und haben einen unterschiedlichen Brechungsindex. Vorteilhaft weist mindestens eine Brechungsschicht einen Brechungsindex n von größer als 1,7, vorzugsweise größer als 2,0 und besonders bevorzugt größer als 2,3 auf. Grundsätzlich gilt, dass je größer der Brechungsindex ist, desto geringer ist die Winkelabhängigkeit des reflektierten Lichts, so dass die Winkelabhängigkeit des Farbeindrucks weiter reduziert werden kann.

Vorteilhaft enthält die optische Interferenzschicht mindestens eine Verbindung, gewählt aus TiOₓ, ZrOₓ, SiC und Si₃N₄, also nichtabsorbierende Materialien mit einem höheren Brechungsindex. Weist die optische Interferenzschicht zwei, drei oder mehr Lagen auf, enthält die optische Interferenzschicht vorzugsweise mindestens eine Verbindung, gewählt aus MgF₂, Al₂O₃, SiO₂ und Siliziumoxinitrid. Dies sind nichtabsorbierende Verbindungen mit einem relativ niedrigen Brechungsindex.

In dem erfindungsgemäßen Fassadenelement kann aufgrund der Kombination einer strukturierten Oberfläche mit einer optischen Interferenzschicht, die nur eine geringe Anzahl an Brechungsschichten aufweist (z.B. ein bis drei Brechungsschichten) schon ein guter Farbeindruck erreicht werden. Durch die geringe Anzahl an Brechungsschichten wird die Herstellung des Fassadenelements vereinfacht und die Produktionskosten verringern sich.

Vorteilhaft enthält mindestens eine optische Interferenzschicht (insbesondere alle optischen Interferenzschichten) des Fassadenelements genau eine Brechungsschicht (oder besteht aus dieser), deren Brechungsindex n größer als 1,9, bevorzugt größer als 2,3, ist.

Gleichermaßen vorteilhaft enthält mindestens eine optische Interferenzschicht (insbesondere alle optischen Interferenzschichten) des Fassadenelements genau zwei Brechungsschichten (oder besteht aus diesen), wobei eine erste Brechungsschicht mit einen ersten Brechungsindex n1 auf der farbgebenden ersten Scheibe mit einem Brechungsindex nd vorliegt und eine zweite Brechungsschicht mit einem zweiten Brechungsindex n2 auf der ersten Brechungsschicht vorliegt. Für die Beträge (Absolutwerte) der Differenzen der Brechungsindizes gilt: |n1-nd| > 0,3 und |n2-n1| > 0,3 und mindestens einer der Brechungsindizes n1 oder n2 ist größer als 1,9, bevorzugt größer als 2,3.

Gleichermaßen vorteilhaft enthält mindestens eine optische Interferenzschicht (insbesondere alle optischen Interferenzschichten) des Fassadenelements genau drei Brechungsschichten (oder besteht aus diesen), wobei eine erste Brechungsschicht mit einen ersten Brechungsindex n1 auf der farbgebenden ersten Scheibe mit einem Brechungsindex nd vorliegt, eine zweite Brechungsschicht mit einem zweiten Brechungsindex n2 auf der ersten Brechungsschicht vorliegt und eine dritte Brechungsschicht mit einem dritten Brechungsindex n3 auf der zweiten Brechungsschicht vorliegt. Für die Beträge (Absolutwerte) der Differenzen der Brechungsindizes gilt: |n3-n2| > 0,3 und |n2-n1| > 0,3 und |n1-nd| > 0,3. Dabei verhalten sich die Werte der Brechungsindizes alternierend: entweder gilt n1 > n2 und n3 > n2 oder es gilt n1 < n2 und n3 < n2. Zudem ist mindestens einer der Brechungsindizes n1, n2 oder n3 größer als 1,9, bevorzugt größer als 2,3.

Durch die optischen Interferenzschichten mit genau einer, genau zwei oder genau drei Brechungsschichten kann bei vereinfachter Herstellung und geringeren Produktionskosten des Fassadenelements ein homogener Farbeindruck des Fassadenelements erzielt werden. Durch zwei- oder dreilagige Schichten kann die Farbkraft, d.h. Helligkeit und Sättigung, also die Reflexion in einem bestimmten engen Wellenbereich erhöht werden. Durch relativ hohe Brechungsindizes wird die Winkelabhängigkeit reduziert. Interferenzschichten aus Schichtstapeln mit mehr als drei Schichten in Kombination mit der erfindungsgemäß strukturierten farbgebenden ersten Scheibe und den dargestellten Ausgestaltungen liegen ebenfalls im Bereich der Erfindung, sind aber komplexer in der Herstellung. Mit einer Vierfachschicht aus Brechschichten mit alternierend hohen und niedrigen Brechungsindizes kann beispielsweise die Bandbreite des reflektierten Lichts weiter reduziert werden bei verbesserter Transmission.

Im mindestens einen strukturierten Bereich der farbgebenden ersten Scheibe tritt eine Reflexion der einfallenden Lichtstrahlung auch außerhalb des Glanzwinkels mit relativ hoher Intensität auf. Der strukturierte Bereich ist zu diesem Zweck vorzugsweise so ausgebildet, dass ein Reflexions-Haze von mehr als 50%, besonders bevorzugt mehr als 90%, vorliegt. Der Reflexions-Haze lässt sich durch ein im Handel verfügbares Haze-Messgerät bestimmen. Nach ASTM D1003 ist Haze das Verhältnis aus diffusem Anteil des reflektierten Lichts zur Gesamtreflexion.

In dem erfindungsgemäßen Fassadenelement ist mindestens eine Zone vorgesehen sein, in der die Segmente eine mittlere Rauigkeit von weniger als 15% der Schichtdicke der optischen Interferenzschicht auf der Vorderfläche haben, wodurch eine konstruktive bzw. destruktive Interferenz des reflektierten Lichts ermöglicht ist. Vorteilhaft erstreckt sich diese Zone über die gesamte farbgebende erste Scheibe. Gemäß einer Ausgestaltung weist der strukturierte Bereich mindestens eine weitere Zone, d.h. (Teil-)Bereich, auf, in dem die Segmente jeweils eine solche mittlere Rauigkeit aufweisen, dass eine Interferenz an der optischen Interferenzschicht nicht auftritt. Beispielsweise haben die Segmente dort eine mittlere Rauigkeit von 50% bis 100% der Schichtdicke der Interferenzschicht. In diesen Zonen weist das Fassadenelement keine durch die optische Interferenzschicht erzeugte Farbe auf.

Gemäß einer Ausgestaltung des erfindungsgemäßen Fassadenelements ist der Verbund aus erster Scheibe und zweiter Scheibe zur Formung einer Isolierscheibe über einen Abstandhalter mit mindestens einer weiteren Scheibe verbunden. Der grundsätzliche Aufbau von Isolierscheiben ist dem Fachmann bekannt, so dass hier nicht näher darauf eingegangen werden muss.

Des Weiteren erstreckt sich die Erfindung auf die Verwendung des erfindungsgemäßen Fassadenelements als (integraler) Bestandteil einer Gebäudehülle (Gebäudewand) oder einer freistehenden Wand, beispielsweise eine Sichtschutz- oder Lärmschutzwand. Besonders vorteilhaft wird das erfindungsgemäße Fassadenelement als Bestanteil einer vorgehängt-hinterlüfteten Fassade, Pfosten-Riegel-Fassade oder Fensterfassade eingesetzt.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird im Weiteren näher erläutert, wobei Bezug auf die beigefügten Zeichnungen genommen wird. Es zeigen in vereinfachter, nicht maßstäblicher Darstellung:
- Fig. 1-2: verschiedene Ausgestaltungen des erfindungsgemäßen Fassadenelements ohne Rückseitenelement in schematischen Querschnittansichten;
- Fig. 3-5: verschiedene Ausgestaltungen des erfindungsgemäßen Fassadenelements mit mindestens einem Rückseitenelement in schematischen Querschnittansichten;
- Fig. 6-7: verschiedene Ausgestaltungen des erfindungsgemäßen Fassadenelements mit Rückseitenelementen in Aufsicht;
- Fig. 8: eine weitere Ausgestaltung des erfindungsgemäßen Fassadenelements in Form einer Isolierscheibe;
- Fig. 9: eine schematische Querschnittansicht der farbgebenden ersten Scheibe gemäß einer Ausgestaltung des erfindungsgemäßen Fassadenelements;
- Fig. 10: eine schematische Darstellung typischer Lichtverhältnisse an einem erfindungsgemäßen Fassadenelement;
- Fig. 11-14: schematische Darstellungen beispielhafter Lichtwege bei Reflexion im strukturierten Bereich der farbgebenden ersten Scheibe von Figur 9;
- Fig. 15: eine schematische Darstellung der Interferenz von Lichtstrahlen in einer optischen Interferenzschicht;
- Fig. 16-17: weitere Ausgestaltungen der farbgebenden ersten Scheibe des erfindungsgemäßen Fassadenelements in schematischen Querschnittansichten;
- Fig. 18: ein schematische Darstellung beispielhafter Lichtwege bei Reflexion an der farbgebenden ersten Scheibe;
- Fig. 19-20: weitere Ausgestaltungen der farbgebenden ersten Scheibe des erfindungsgemäßen Fassadenelements in schematischen Querschnittansichten;
- Fig. 21: eine schematische Darstellung beispielhafter Lichtwege bei Reflexion im strukturierten Bereich des Fassadenelements von Figur 20;
- Fig. 22: eine weitere Ausgestaltung der farbgebenden ersten Scheibe des erfindungsgemäßen Fassadenelements in einer schematischen Querschnittansicht;
- Fig. 23: eine schematische Darstellung beispielhafter Lichtwege bei Reflexion an der farbgebenden ersten Scheibe des Fassadenelements von Figur 22;
- Fig. 24-25: weitere Ausgestaltungen der farbgebenden ersten Scheibe des erfindungsgemäßen Fassadenelements in schematischen Querschnittansichten;
- Fig. 26: eine schematische Darstellung des Messverfahrens zur MehrwinkelFarbmessung.

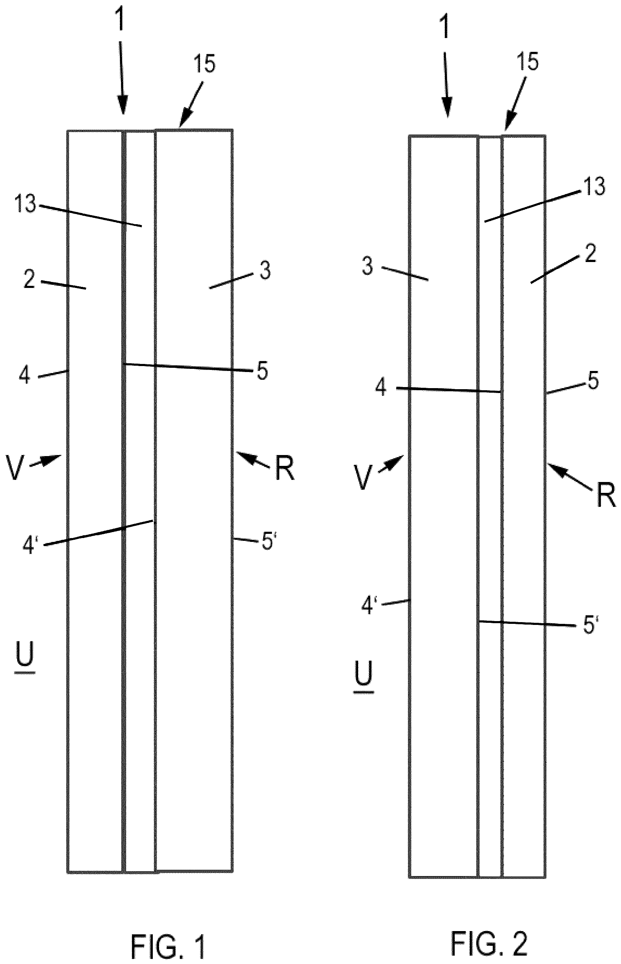

In Figur 1 und 2 ist der Aufbau eines insgesamt mit der Bezugszahl 1 bezeichneten Fassadenelements gemäß einem Ausführungsbeispiel vorliegender Erfindung in schematischer Weise anhand einer Querschnittansicht (Schnitt senkrecht zur Oberfläche des Fassadenelements) veranschaulicht. Das Fassadenelement 1 dient zum Einbau in eine Fassade. Beispielsweise kann das Fassadenelement 1 als Paneel einer hinterlüfteten Fassade dienen, in die Ausfachung eines Pfosten-Riegel Tragwerks eingesetzt werden oder ein Fensterelement in einer Fensterwand sein.

Das Fassadenelement 1 umfasst eine transparente oder semi-transparente, farbgebende erste Scheibe 2 und eine mechanisch unterstützende zweite Scheibe 3, welche durch eine Zwischenschicht 13 fest miteinander verbunden sind (z.B. durch Lamination). Die erste Scheibe 2 und die zweite Scheibe sind beispielsweise Glasscheiben und bestehen aus einem Glas, das vorzugsweise eine geringe Absorption aufweist, wie zum Beispiel Kalknatronglas. Im Weiteren wird die erste Scheibe 2 auch als farbgebendes Glaselement, die zweite Scheibe 3 als mechanisch unterstützendes Glaselement bezeichnet.

Das Fassadenelement 1 hat eine Vorderseite V, welche von der äußeren Umgebung her betrachtet werden soll (Seite des Lichteinfalls), sowie eine Rückseite R, welche im verbauten Zustand einer in aller Regel flächigen Struktur (z.B. Wand) gegenüberliegt. Als äußere Umgebung wird im Sinne der vorliegenden Erfindung der Umgebungsbereich U der Vorderseite V des Fassadenelements 1 betrachtet (in Figur 1 und 2 jeweils der Umgebungsbereich U, der sich links des Fassadenelements 1 befindet).

Die farbgebende erste Scheibe 2 umfasst eine der äußeren Umgebung U zugewandte Vorderfläche 4 und gegenüberliegend eine von der äußeren Umgebung U abgewandte Rückfläche 5. Analog hierzu weist die zweite Scheibe 3 eine der äußeren Umgebung U zugewandte Vorderfläche 4' und gegenüberliegend eine von der äußeren Umgebung abgewandte Rückfläche 5' auf. Im Sinne vorliegender Erfindung werden Flächen als "Vorderflächen" bezeichnet, wenn sie der äußeren Umgebung U zugewandt sind. Entsprechend werden Flächen als "Rückflächen" bezeichnet, wenn sie von der äußeren Umgebung U abgewandt sind. Möglich wäre auch, dass die erste Scheibe 2 und/oder die zweite Scheibe 3 jeweils als Verbundkörper ausgebildet sind und insbesondere aus einem transparenten Kern bestehen, der in ein anderes transparentes Material eingebettet ist (z.B. Sandwich-artig), welches den gleichen optischen Brechungsindex hat wie der Kern. Die Vorderfläche 4, 4' und Rückfläche 5, 5' werden dann von diesem Material gebildet. Dies ist in Figur 1 nicht näher dargestellt.

Die erste Scheibe 2 ist mit der zweiten Scheibe 3 durch eine Verklebung, z.B. durch eine Laminierfolie, transparentes Silikon oder Gießharz zu einem Verbundglaselement verbunden. Die erste Scheibe 2 liegt hier beispielsweise außen, d.h. bildet die Vorderseite V des Fassadenelements 1. Die zweite Scheibe 3 liegt innen, d.h. bildet die Rückseite R des Fassadenelements 1.

Das Fassadenelement 1, das eine Verbundscheibe 15 aus erster Scheibe 2 und zweiter Scheibe 3 umfasst, übernimmt sowohl eine mechanische Funktion (Windlast) als auch eine witterungsschützende Funktion (Regen etc.). Je nach statisch-strukturellen Anforderungen müssen die Dicken der Scheiben 2, 3 entsprechend dimensioniert werden. Die beiden Scheiben 2, 3 bestehen je nach baulichen Anforderungen vorzugsweise aus veredeltem Glas, wie beispielsweise thermisch gehärtetes Glas, so genanntes Einscheibensicherheitsglas (ESG), oder teilvorgespanntes Glas (TVG).

Die erste Scheibe 2 ist zum Zwecke der Farbgebung beschichtet und texturiert, was weiter unten näher erläutert wird. Die zweite Scheibe 3 dient zum mechanischen Unterstützen (d.h. Verstärken) der farbgebenden ersten Scheibe 2 und trägt wesentlich zur mechanischen Stabilität des Fassadenelements 1 bei, so dass es auch größeren Windlasten standhalten kann.

In dem in Figur 1 gezeigten Ausführungsbeispiel ist die farbgebende erste Scheibe 2 dünner als die mechanisch unterstützende zweite Scheibe 3. Beispielsweise weist die erste Scheibe eine Scheibendicke im Bereich von 2 - 4 mm auf. Die zweite Scheibe 3 ist dicker als die erste Scheibe 2 und weist beispielsweise eine Scheibendicke von mehr als 4 mm auf.

In Figur 2 ist eine Variante von Figur 1 gezeigt, welche sich von Figur 1 nur dadurch unterscheidet, dass die mechanisch unterstützende zweite Scheibe 3 die äußerste Scheibe des Fassadenelements 1 ist, also die Vorderseite V des Fassadenelements 1 bildet. Dahinter befindet sich die farbgebende erste Scheibe 2.

Im Fassadenelement 1 von Figur 1 und 2 ist die farbgebende erste Scheibe 2 mit der zweiten Scheibe 3 fest verbunden (z.B. durch Lamination) und beide zusammen bilden eine farbige Verbundscheibe 15. Das Fassadenelement 1 weist beispielsweise kein Rückseitenelement auf. Die Farbe des Fassadenelements 1 kann insbesondere durch einen farbigen Hintergrund, welcher nicht Teil des Fassadenelements 1 ist, beeinflusst werden.

Vorzugsweise verfügt das Fassadenelement 1 an seiner Rückseite R über mindestens ein flächiges Rückseitenelement, welche beispielsweise ein fotovoltaisch passives Rückseitenelement ist. Vorzugsweise ist das flächige Rückseitenelement opak. Das fotovoltaisch passive Rückseitenelement ist beispielsweise in Form einer z.B. vollflächigen Beschichtung, insbesondere einer opaken Beschichtung, der Rückfläche 5', 5 der rückseitigen Scheibe (erste Scheibe 2 oder zweite Scheibe 3) ausgebildet. Gleichermaßen kann das Rückseitenelement beispielsweise in Form einer mit der Rückfläche 5', 5 der rückseitigen Scheibe (erste Scheibe 2 oder zweite Scheibe 3) fest verbundenen Folie, insbesondere einer opaken Folie, oder eines starren Körpers, insbesondere eines opaken starren Körpers, beispielsweise in Plattenform, ausgebildet sein. Dies ist in den Figuren nicht näher dargestellt.

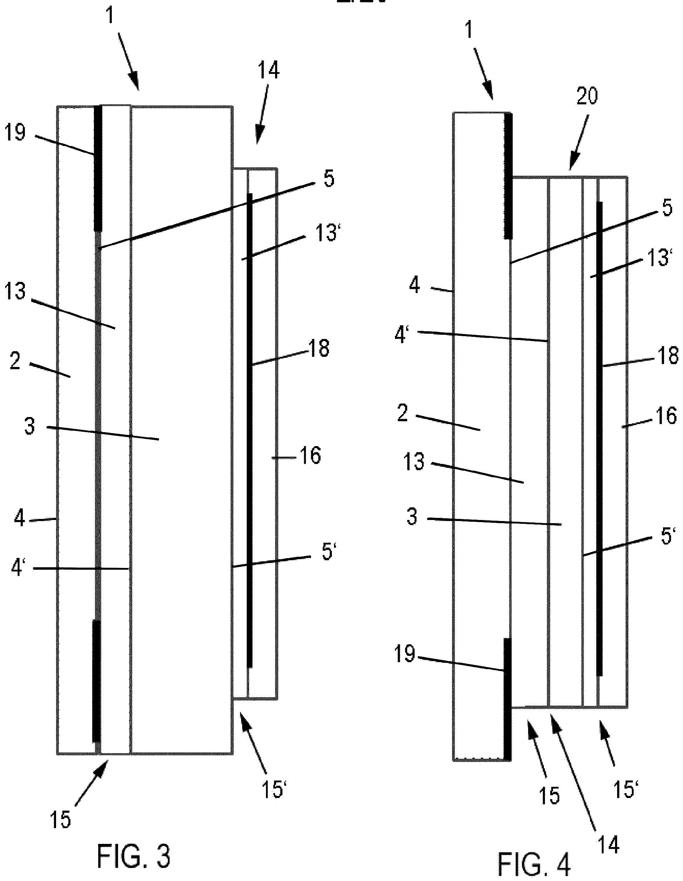

Besonders bevorzugt weist das farbige Fassadenelement 1 mindestens ein flächiges Rückseitenelement auf, welches fotovoltaisch aktiv ist, d.h. zur Energieerzeugung aus Sonnenlicht geeignet und bestimmt ist. Das farbige Fassadenelement 1 kann somit in vorteilhafter Weise zur fotovoltaischen Energieerzeugung eingesetzt werden. Derartige Ausgestaltungen sind in den Figuren 3 bis 5 veranschaulicht.

Sei zunächst Figur 3 betrachtet. Darin gezeigt ist ein Fassadenelement 1, wie es bereits in Verbindung mit Figur 1 erläutert wurde. Auf die entsprechenden Ausführungen zu Figur 1 wird Bezug genommen. Ergänzend weist das Fassadenelement 1 ein fotovoltaisch aktives Rückseitenelement 14 auf. Das Rückseitenelement 14 umfasst ein hier beispielsweise gläsernes Trägersubstrat 16 (Glasscheibe), auf dem eine Mehrzahl seriell verschalteter Solarzellen 18 ausgebildet sind. Das Trägersubstrat 16 ist direkt, d.h. ohne zwischenliegende Scheibe, mit der rückseitigen Scheibe (hier z.B. zweite Scheibe 3) der Verbundscheibe 15 aus erster Scheibe 2 und zweiten Scheibe 3 durch eine weitere Zwischenschicht 13' fest verbunden (z.B. durch Lamination). Die rückseitige Scheibe 3 bildet mit dem Trägersubstrat 16 somit eine weitere Verbundscheibe 15' aus. Insgesamt ergibt sich eine Verbundscheibenstruktur, bei der die beiden Scheiben 2, 3 sowie das Trägersubstrat 16, durch Lamination fest miteinander verbunden sind. Die weitere Zwischenschicht13' zum festen Verbinden von rückseitiger Scheibe 3 und Trägersubstrat 16 ist vorzugsweise eine thermoplastische oder vernetzende Polymer-Zwischenschicht (z.B. PVB oder EVA).

Die Solarzellen 18 sind durch die Verbundscheibe 15 aus erster Scheibe 2 und zweiter Scheibe 2 gut gegen äußere Witterungseinflüsse geschützt. Vorzugsweise handelt es sich bei den Solarzellen 18 um Dünnschicht-Solarzellen, bei denen die fotovoltaisch aktive Absorberschicht aus einem Chalkopyrit-Halbleiter, insbesondere aus einem ternären I-III-VI-Verbindungshalbleiter aus der Gruppe Kupfer-Indium/Gallium-Disulfid/Diselenid (Cu(In,Ga)(S,Se)₂) besteht.

In Figur 4 ist eine Variante zu Figur 3 gezeigt, welche sich von der Ausgestaltung von Figur 3 dadurch unterscheidet, dass die zweite Scheibe 3 dünner ist als die farbgebende erste Scheibe 2. Zudem ist die zweite Scheibe 3 kleiner als die erste Scheibe 2 und entspricht in ihren Dimensionen dem Trägersubstrat 16. Die zweite Scheibe 3 ist hier in Form einer Deckplatte für das Trägersubstrat 16 mit Solarzellen 18 ausgebildet. Bei der Herstellung des Fassadenelements 1 kann ein vorgefertigtes Solarmodul 20, welches die zweite Scheibe 3 als Deckplatte und das Trägersubstrat 16 mit Solarzellen 18 umfasst, mit der ersten Scheibe 2 laminiert werden. Dies kann verfahrenstechnisch vorteilhaft sein, da das Solarmodul 20 vorfertigbar ist. Das Rückseitenelement 14 entspricht dann dem kompletten Solarmodul 20. Die Größe des Solarmoduls 20 in der Ebene des Trägersubstrats 16 ist kleiner als jene der ersten Scheibe 2, so dass das Solarmodul 20 gut gegen äußere Einflüsse geschützt ist. Möglich wäre auch, die farbgebende erste Schiebe 2 als Deckplatte des Solarmoduls 20 auszubilden (mit entsprechend gleicher Größe wie das Trägersubstrat 16), und das Solarmodul 20 dann mit der frontseitig angeordneten, mechanisch unterstützenden zweiten Scheibe 3 fest zu verbinden.

In den Ausgestaltungen der Figuren 3 und 4 ist mindestens eine Maskierungsschicht 19 hinter der letzten Interferenzschicht (siehe unten), d.h. hinter der farbgebenden ersten Scheibe 2 angeordnet. In Figur 3 und 4 ist die Maskierungsschicht 19 jeweils auf der Rückfläche 5 der ersten Scheibe 2 aufgebracht. Die Maskierungsschicht 19 bedeckt die Rückfläche 5 nur teilweise, wobei die fotovoltaisch inaktiven Bereiche überdeckt werden. Die fotovoltaisch aktiven Bereiche der Solarzellen 18 werden nicht überdeckt. Dies verbessert die äußere Erscheinung des Fassadenelements 1.

In der Ausgestaltung von Figur 3 ist das farbgebende Glaselement dünn. Beispielsweise liegt die Scheibendicke im Bereich von 2 - 4 mm. Das mechanisch unterstützende Glaselement ist dicker. Beispielsweise beträgt die Scheibendicke mehr als 4 mm. Hinter dem mechanisch unterstützenden Glaselement sind ein oder mehrere Trägersubstrate 16 mit Solarzellen 18 (ohne Frontglas) oder auch Glasscheiben mit Strings aus Silizium-Wafer-Solarzellen oder eine Rückseitenfolie mit Strings aus Silizium-Wafer-Solarzellen auflaminiert. Die nicht aktiven Bereiche (Kontaktbänder, Randzonen, Zwischenbereiche, Passstücke) werden dabei von der opaken Maskierungsschicht 19 abgedeckt. Die opake Maskierungsschicht 19 befindet sich bevorzugt auf der Rückfläche 5 (d.h. Seite 2) des farbgebenden Glaselements oder auf der Vorderfläche 4' (d.h. Seite 3) oder der Rückfläche 5' (d.h. Seite 4) des mechanisch unterstützenden Glaselements. Durch die opake Maskierungsschicht 19 zwischen den aktiven Bereichen bleiben auch Kabel, Stecker oder Anschlussdosen verborgen. Die Verbundscheibe 15 aus dem farbgebenden und dem mechanisch unterstützenden Glaselement kann dabei größer als die Fläche des einen oder der mehreren Trägersubstrate 16 sein, wenn die Randbereiche zur Befestigung mit Linienlagerung, Punktlagerung oder Verklebung benötigt werden. Für die Laminierung des einen oder der mehreren Trägersubstrate 16 können verschiedene bekannte Laminierungsfolien wie PVB, EVA, vernetzendes TPO u.a. verwendet werden. Es können Standardgrößen und relativ dünne Trägersubstrat-Glasscheiben verwendet werden. Das ist vorteilhaft bei der Herstellung der Dünnschichtsolarmodule.

In der Ausgestaltung von Figur 4 befindet sich das farbgebende Glaselement außen. In diesem Fall ist es eher dick (z.B. Scheibendicke im Bereich von 3 - 10 mm), da es einen wesentlichen Teil der mechanischen Stabilisierung übernimmt. Das mechanisch unterstützende Glaselement ist in diesem Fall dünner und kann in Breite und/oder Höhe auch kleiner sein als das farbgebende Glaselement. Das mechanisch unterstützende Glaselement ist hier die Frontscheibe des Solarmoduls 20. Die Einführung des mechanisch unterstützenden Glaselementes hat produktionstechnische Vorteile. Das Solarmodul 20 kann somit als Serienprodukt bei einem Modulhersteller komplett mit Frontglas und Anschlussdosen gefertigt werden und damit als bereits versiegeltes Element bei einem Hersteller von Glasfassaden weiterverarbeitet werden. Wie in Figur 3 können die nicht aktiven Bereiche (Kontaktbänder, Randzonen, Zwischenbereiche, Passstücke) von der opaken Maskierungsschicht 19 abgedeckt werden. Die opake Maskierungsschicht 19 befindet sich dabei bevorzugt auf der Rückfläche 5 (d.h. Seite) des farbgebenden Glaselements. Durch die opake Maskierungsschicht 19 zwischen den aktiven Bereichen bleiben auch Kabel, Stecker oder Anschlussdosen verborgen. Der Verbundscheibe 15 aus dem farbgebenden und dem mechanisch unterstützenden Glaselement kann größer als die Fläche des einen oder der mehreren Solarmodule 20 sein.

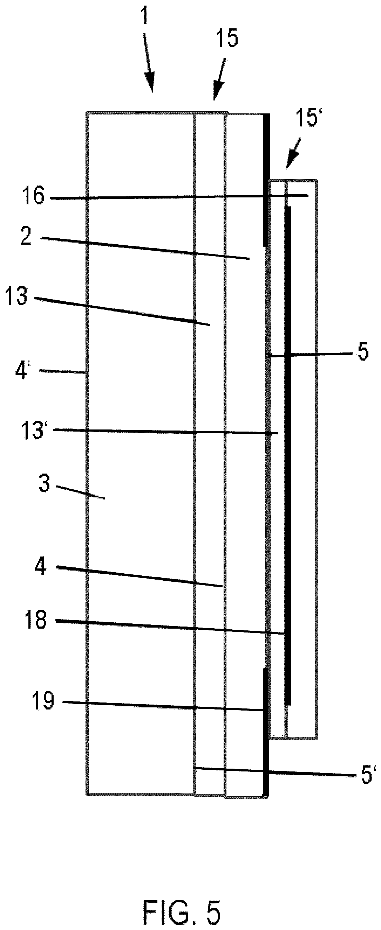

In Figur 5 ist eine Variante der Ausgestaltung von Figur 3 gezeigt. Diese unterscheidet sich von Figur 3 dahingehend, dass das mechanisch unterstützende Glaselement die äußerste Glasscheibe des Fassadenelements 1 ist. Dahinter befindet sich das farbgebende Glaselement. Das farbgebende Glaselement ist vergleichsweise dünn (Scheibendicke z.B. im Bereich 2 - 4 mm). Das farbgebende Glaselement wird auf das mechanisch unterstützende Glaselement auflaminiert und beide zusammen bilden das farbige Verbundglaselement bzw. Verbundscheibe 15' aus. Hinter dem farbgebenden Glaselement werden ein oder mehrere Trägersubstrate 16 mit Solarzellen 18, vorzugsweise Dünnschichtzellen oder auch Trägersubstrate mit Strings aus Silizium-Wafer-Solarzellen oder eine Rückseitenfolie mit Strings aus Silizium-Wafer-Solarzellen auflaminiert. Die nicht aktiven Bereiche (Kontaktbänder, Randzonen, Zwischenbereiche, Passstücke) können dabei mit mindestens einer opaken Maskierungsschicht 19 abgedeckt werden. Die mindestens eine opake Maskierungsschicht 19 befindet sich bevorzugt auf der Innenfläche 5 (Seite 4) des farbgebenden Glaselements. Durch die mindestens eine opake Maskierungsschicht 19 zwischen den aktiven Bereichen bleiben auch Kabel, Stecker oder Anschlussdosen verborgen. Werden mehrere Trägersubstrate 16 (Circuits) mit (Dünnschicht-)Solarzellen 18 auflaminiert, so sind deren Rückseiten (Substratgläser) nicht verbunden.

Je nach Ausgestaltung der Lieferkette kann das Solarmodul in der Solarmodul-Produktionsstätte direkt mit dem farbgebenden Glaselement laminiert werden und dann als gut versiegeltes und geprüftes Solarmodul zum Hersteller der Fassadenelemente geliefert werden.

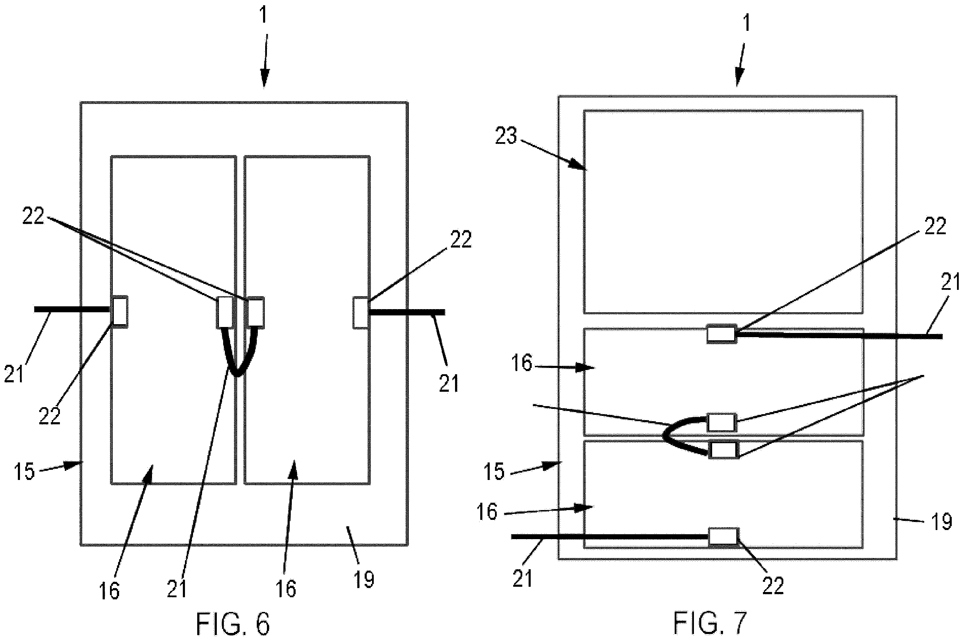

In Figur 6 und 7 sind verschiedene Ausgestaltungen des Fassadenelements 1 jeweils in einer Aufsicht auf die Rückseite R dargestellt. Das Fassadenelement 1 basiert auf den Ausgestaltungen von Figur 3 oder 5. Demnach sind hier beispielsweise zwei Trägersubstrate 16 mit Solarzellen 18 (Circuits) auf den Verbund 15 aus erster Scheibe 2 und zweiter Scheibe 3 auflaminiert. Die Solarzellen 18 der beiden Trägersubstrate 16 sind durch Anschlussleitungen 21 und Anschlussdosen 22 miteinander in Serie oder parallel verschaltet. Zudem werden hierdurch Außenanschlüsse geschaffen. In der Ausgestaltung von Figur 7 ist neben den beiden Trägersubstraten 16 mit Solarzellen 18 (Circuits) zudem ein transparentes Fenster 23 vorgesehen. Die opake Maskierungsschicht 19 deckt die fotovoltaisch inaktiven Bereiche ab.

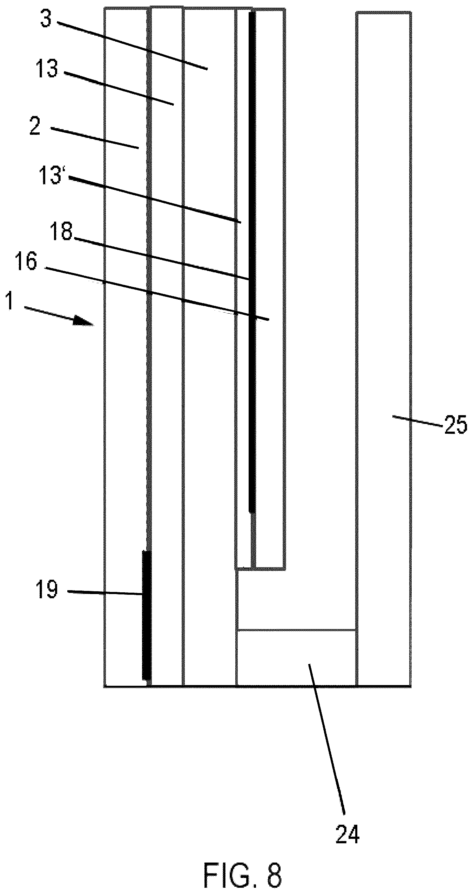

In Figur 8 ist eine Ausgestaltung des Fassadenelements 1 als Isolierscheibe veranschaulicht. Hierbei ist der Verbundscheibe 15, 15' aus erster Scheibe 2, zweiter Scheibe 3 und Trägersubstrat 16 mit Solarzellen 18 über einen Abstandhalter 24 mit einer weiteren Isolierglasscheibe fest verbunden.

Je nach Ausgestaltung des Fassadenelements 1 ist die Vorderfläche 4 und/oder die Rückfläche 5 der farbgebenden ersten Scheibe 2 strukturiert (z.B. durch Ätzung, Sandstrahlen oder Walzen beim Ziehprozess) und weist mindestens eine optische Interferenzschicht auf, was in den Figuren 1 bis 8 nicht dargestellt ist. Dies wird im Weiteren näher erläutert.

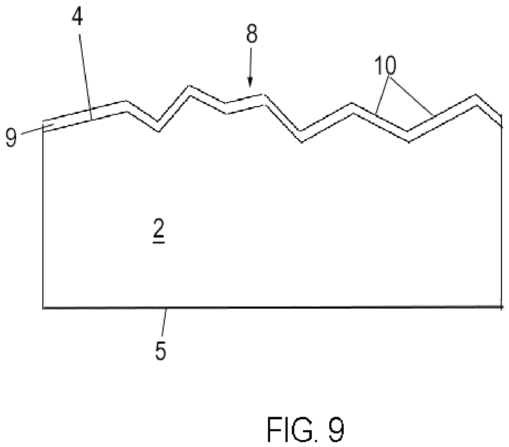

In Figur 9 ist eine Ausgestaltung des erfindungsgemäßen Fassadenelements 1 veranschaulicht, wobei lediglich die farbgebende erste Scheibe 2 mit einer beispielhaften Strukturierung gezeigt ist. Das Fassadenelement 1 kann insbesondere wie in den Figu- ren 1 bis 8 ausgebildet sein. Demnach ist die Vorderfläche 4 der farbgebenden ersten Scheibe 2 in einem Bereich 8 strukturiert, welcher sich im vorliegenden Beispiel über die komplette Vorderfläche 4 erstreckt, d.h. Vorderfläche 4 und strukturierter Bereich 8 sind identisch. Unmittelbar auf der Vorderfläche 4 ist eine optische Interferenzschicht 9 angeordnet. Im strukturierten Bereich 8 ist die Vorderfläche 4 mit einem Höhenprofil versehen, das Berge und Täler aufweist. Hierbei bestehen mehr als 50% der Vorderfläche 4 aus ebenen Segmenten 10, deren Ebenen jeweils zur Ebene der farbgebenden ersten Scheibe 2 geneigt sind, d.h. einen von Null verschiedenen Winkel zur Ebene der farbgebenden ersten Scheibe 2 aufweisen. Die Segmente 10 haben jeweils eine Segmentfläche von mindestens 1 µm² und eine mittlere Rauigkeit von weniger als 15% der Schichtdicke d der optischen Interferenzschicht 9. Ein mittlerer Höhenunterschicht zwischen den höchsten Punkten (Berge) und niedrigsten Punkten (Täler) der Vorderfläche 4 beträgt mindestens 2 µm und beispielsweise maximal 20% der Dicke der farbgebenden ersten Scheibe 2. Bezogen auf die Ebene der farbgebenden ersten Scheibe 2 haben mindestens 20% der Segmente einen Neigungswinkel im Bereich von größer als 0° bis maximal 15°, mindestens 30% der Segmente einen Neigungswinkel im Bereich von größer als 15° bis maximal 45° und weniger als 30% der Segmente 10 einen Neigungswinkel von größer als 45°. Im Ausführungsbeispiel von Figur 9 haben alle Segmente einen Neigungswinkel von maximal 45°.

Die optische Interferenzschicht 9 ist dünn und weist eine Schichtdicke beispielsweise im Bereich von 0,1 bis einige (z.B. 2) Mikrometer auf. Ferner hat die optische Interferenzschicht 9 einen Brechungsindex n von größer als 1,7, vorzugsweise größer als 2,0 und besonders bevorzugt größer als 2,3, sowie eine möglichst geringe Absorption in Bezug auf das einfallende Licht. Die optische Interferenzschicht 9 kann ein- oder mehrlagig ausgebildet sein, d.h. aus einer oder mehreren Brechungsschichten bestehen. Jede Brechungsschicht weist einen bestimmten Brechungsindex auf und besteht aus demselben Material. Beispielsweise besteht die optische Interferenzschicht 9 aus MgO, SiONx, Si₃N₄, ZrO₂, TiOx und/oder SiC. Die elektrische Leitfähigkeit der einzelnen Brechungsschichten, insbesondere der optischen Interferenzschicht 9, sollte möglichst gering sein.

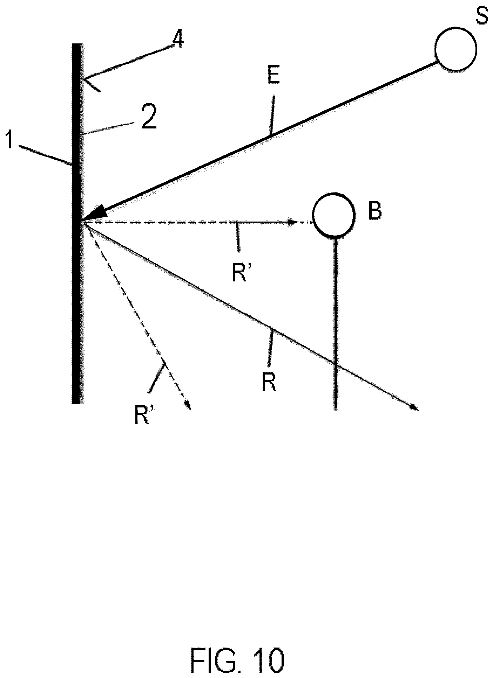

Im Weiteren wird die Funktionsweise der Strukturierung der Vorderfläche 4 der farbgebenden ersten Scheibe 2 näher beschrieben. Sei zunächst Figur 10 betrachtet, worin beispielhaft typische Lichtverhältnisse bei einem Fassadenelement 1 veranschaulicht sind. Demnach trifft Licht von der Sonne S direkt auf die farbgebende erste Scheibe 2 und wird im Glanzwinkel reflektiert. Der einfallende Lichtstrahl E und der im Glanzwinkel reflektierte Lichtstrahl R sind gezeigt. Neben dem reflektierten Lichtstrahl R wird das einfallende Licht auch außerhalb des Glanzwinkels diffus gestreut. Zwei diffus gestreute Lichtstrahlen R' sind beispielhaft gezeigt. Der Farbeffekt entsteht durch Reflexion, Streuung und Interferenz. Steht ein Beobachter B vor dem Fassadenelement 1 und blickt senkrecht auf die farbgebende erste Scheibe 2 vor ihm, trifft sein Auge nur in den seltensten Fällen das direkt reflektierte Licht R (d.h. der Beobachter steht meist nicht im Glanzwinkel). Dies ist in Figur 10 veranschaulicht, wo sich der Beobachter B außerhalb des Glanzwinkels befindet und nur den diffus gestreuten Lichtstrahl R' sieht. Bei einer glatten Oberfläche ohne strukturierten Bereich 8 ist die Intensität des diffus gestreuten Lichts R' relativ gering und weist eine starke Winkelabhängigkeit auf. Erst wenn der diffus gestreute Anteil ausreichend groß ist, gibt es eine deutliche Farbe mit zufriedenstellender Intensität (Helligkeit, L-Wert).

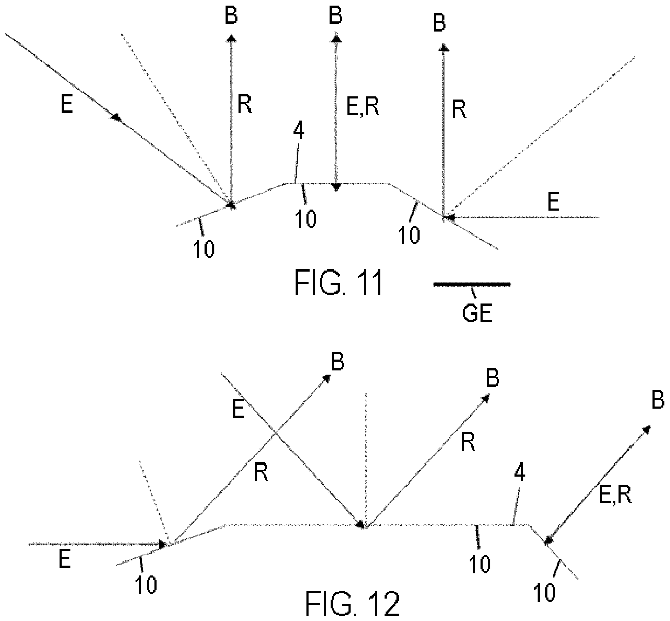

Das Grundprinzip der Wirkungsweise der geneigten Segmente 10 des strukturierten Bereichs 8 ist in Figur 11 veranschaulicht, worin beispielhaft die verschiedenen Lichtwege für einen Beobachter B gezeigt sind, der senkrecht auf die Glasoberfläche bzw. Vorderfläche 4 des Fassadenelements 1 blickt. Gezeigt sind drei Segmente 10 mit verschiedenen Neigungen zur schematisch veranschaulichten Ebene GE der farbgebenden ersten Scheibe 2, sowie die auf die Segmente 10 treffenden Lichtstrahlen E, die von den Segmenten 10 jeweils im lokalen Glanzwinkel zum Beobachter B reflektiert werden (reflektierte Lichtstrahlen R). Das mittlere Segment 10 ist parallel zur Ebene GE angeordnet, wobei der einfallende Lichtstrahl E senkrecht auf das Segment 10 trifft und senkrecht zum Beobachter B reflektiert wird (reflektierter Strahl R). Für das mittlere Segment 10 sind Glanzwinkel und lokaler Glanzwinkel identisch. Bei den beiden angrenzenden Segmenten 10 haben die einfallenden Lichtstrahlen E jeweils einen von Null verschiedenen Winkel zur Oberflächennormalen auf die Ebene GE und treffen ebenfalls im lokalen Glanzwinkel auf den Beobachter B. Aufgrund der unterschiedlichen Neigungen der Segmente 10 wird Licht aus verschiedenen Richtungen jeweils im lokalen Glanzwinkel der Segmente 10 zu dem senkrecht auf die Modulfläche blickenden Beobachter B reflektiert. Im Ausführungsbeispiel von Figur 11 betragen Ein- und Ausfallswinkel maximal 45°.

In Figur 12 ist eine Situation gezeigt, bei der der Beobachter B in einem Winkel von 45° zur Oberflächennormalen auf die Ebene GE der farbgebenden ersten Scheibe 2 sieht. Wie in Figur 11 sind beispielhaft drei Segmente 10 mit verschiedenen Neigungen zur Ebene GE der farbgebenden ersten Scheibe 2 gezeigt, sowie die jeweils auf die Segmente 10 treffenden Lichtstrahlen E, die von den Segmenten 10 im lokalen Glanzwinkel zum Beobachter B reflektiert werden (reflektierte Lichtstrahlen R). Aufgrund der unterschiedlichen Neigungen der Segmente 10 wird Licht aus verschiedenen Richtungen jeweils im lokalen Glanzwinkel zu dem auf die Modulfläche blickenden Beobachter B reflektiert. Im Ausführungsbeispiel von Figur 12 betragen Ein- und Ausfallswinkel maximal 67,5°. Grundsätzlich gilt, dass bei relativ großen Werten des Glanzwinkels das reflektierte Licht blauverschoben ist. Diese Blauverschiebung kann durch einen höheren Brechungsindex der optischen Interferenzschicht reduziert werden. Bei relativ steilen Flächenneigungen kann es auch zur Mehrfach-Reflexion an benachbarten Facetten kommen.

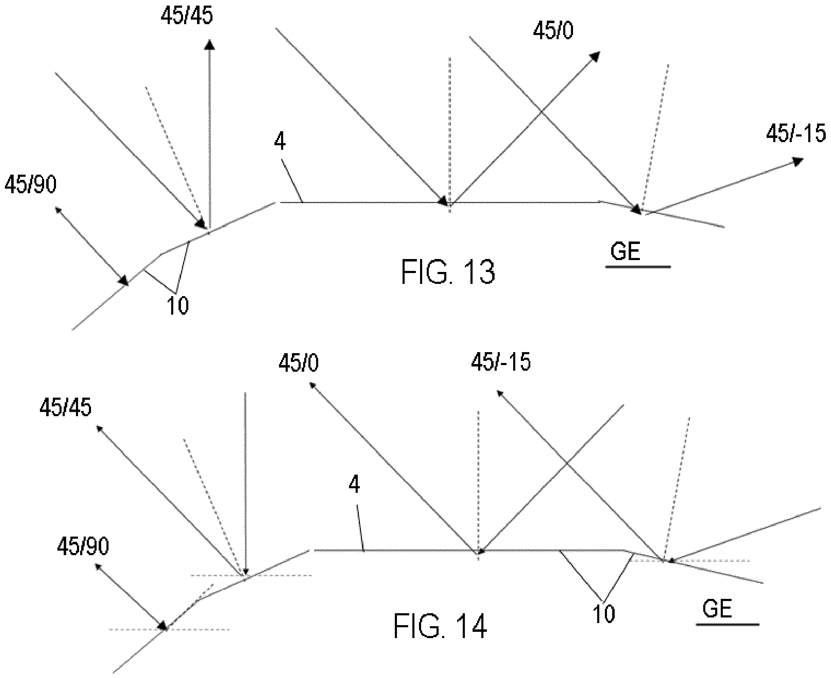

In Figur 13 ist eine Situation gezeigt, bei der die Lichtquelle und dementsprechend die einfallenden Lichtstrahlen stets in einem Winkel von 45° zur Ebene GE der farbgebenden ersten Scheibe 2 geneigt sind. Der Beobachter B betrachtet die Oberfläche des Fassadenelements 1 unter verschiedenen Winkeln. Die Winkelangaben in Figur 13 sind wie folgt zu verstehen: Einfallswinkel (bezogen auf Ebene GE der Farbgebende erste Scheibe 2) / Beobachtungs- bzw. Reflexionswinkel (Abweichung vom Glanzwinkel bezogen auf Oberflächennormale auf Ebene GE). Das Gradzeichen "°" ist nicht angegeben. In Figur 13 sind beispielhaft vier Segmente 10 mit verschiedenen Neigungen zur Ebene GE gezeigt. Lediglich in einem Segment 10, dessen Ebene parallel zur Ebene der farbgebenden ersten Scheibe 2 ist, befindet sich der Beobachter B im Glanzwinkel in Bezug auf die Ebene GE: 45/0. Dies bedeutet, dass der einfallende Lichtstrahl einen Winkel von 45° zur Ebene GE hat, der reflektierte Lichtstrahl eine Winkelabweichung Null vom Glanzwinkel. Bei den anderen Segmenten 10 befindet sich der Beobachter B außerhalb des Glanzwinkels. Bei den beiden linken Segmenten 10 (45/90, 45/45) betrachtet der Beobachter die Oberfläche des Fassadenelements 1 in einem Winkel von 90° bzw. 45° zum Glanzwinkel, wobei das Licht in einem Winkel von 45° zur Ebene GE einfällt. Beim rechten Segment 17 (45/-15) befindet sich der Beobachter in einem Winkel von -15° zum Glanzwinkel. Aufgrund der verschieden geneigten Segmente 10 und der hierdurch bedingten Reflexion im lokalen Glanzwinkel wird auch dann Licht mit hinreichender Intensität zum Beobachter B reflektiert, wenn sich der Beobachter nicht im Glanzwinkel, bezogen auf die Ebene GE der farbgebenden ersten Scheibe 10, befindet.

In Figur 14 ist eine Situation gezeigt, bei der der Beobachter B die Oberfläche des Fassadenelements 1 stets in einem Winkel von 45° zur Moduloberfläche bzw. Ebene GE der farbgebenden ersten Scheibe 2 beobachtet. In Figur 14 sind beispielhaft vier Segmente 10 mit verschiedenen Neigungen zur Ebene GE gezeigt. Lediglich in einem Segment 10, dessen Ebene parallel zur Ebene GE ist, befindet sich der Beobachter B im Glanzwinkel: 45/0. Bei den anderen Segmenten 10 befindet sich der Beobachter B außerhalb des Glanzwinkels. Bei den beiden linken Segmenten 10 (45/90, 45/45) betrachtet der Beobachter B die Oberfläche des Fassadenelements 1 in einem Winkel von 45°, wobei das Licht in einer Abweichung von 90° bzw. 45° relativ zum Glanzwinkel einfällt. Beim rechten Segment 10 (45/-15) fällt das Licht in einem Winkel von -15° zum Glanzwinkel ein. Aufgrund der verschieden geneigten Segmente 10 und der hierdurch bedingten Reflexion im lokalen Glanzwinkel wird auch dann Licht mit hinreichender Intensität zum Beobachter B reflektiert, wenn Licht außerhalb des Glanzwinkels einfällt.

In dem erfindungsgemäßen Fassadenelement 1 kann durch die Strukturierung der Vorderfläche 4 der farbgebenden ersten Scheibe 2 in Kombination mit der farbgebenden optischen Interferenzschicht 9 ein homogener Farbeeindruck in einem vorgebbaren Wellenlängenbereich erreicht werden, wobei der Farbeindruck im Vergleich zu einer nichtstrukturierten Oberfläche weitaus weniger winkelabhängig ist.

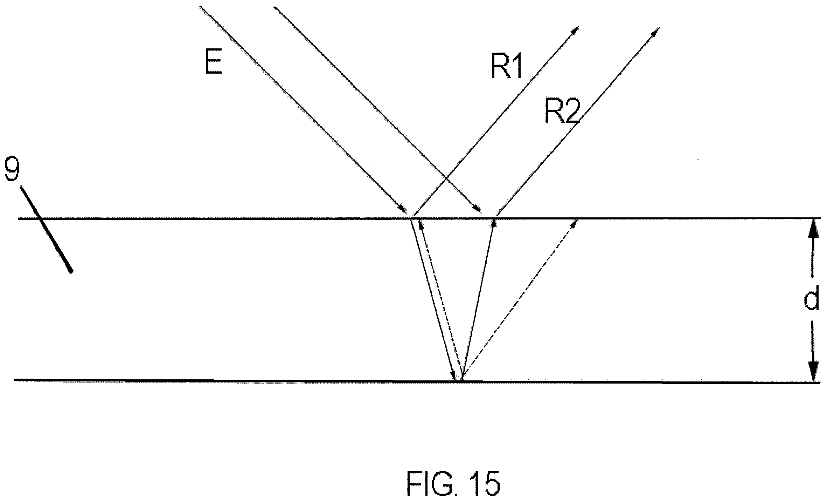

In Figur 15 ist die Reflexion an der optischen Interferenzschicht 9 mit Schichtdicke d veranschaulicht. Der einfallende Lichtstrahl E wird sowohl an der Grenzfläche Atmosphäre-Interferenzschicht (R1) als auch an der Grenzfläche Interferenzschicht-Scheibe (R2) reflektiert. Falls der Gangunterschied der beiden Lichtstrahlen R1, R2 einem Vielfachen der Wellenlänge des einfallenden Lichtstrahls entspricht, tritt konstruktive Interferenz auf, bei einem Gangunterschied von einem Vielfachen der halben Wellenlänge destruktive Interferenz. Bei Beleuchtung mit weißem Licht wirkt die optische Interferenzschicht 9 somit als Farbfilter, da konstruktive Interferenz, abhängig vom Brechungsindex n und Schichtdicke d, nur für Licht geeigneter Wellenlänge auftritt. Hierbei ist α der Winkel der reflektierten Strahlen R1, R2, zur Oberflächennormalen. Die Lichtstrahlen R' veranschaulichen beispielhaft das reflektierte Licht außerhalb des Glanzwinkels, welche im strukturierten Bereichs 15 auftreten können, wenn die Rauigkeit der Grenzfläche zwischen Interferenzschicht-Scheibe zu groß ist. Um die Interferenzbedingung zu erfüllen, ist es erforderlich, dass die Streuzentren jeweils kleiner als Wellenlänge und Schichtdicke sind. Weiterhin können R1 und R2 nur interferieren, wenn diese noch auf demselben ebenen Oberflächensegment liegen. Die farbgebende Interferenz kann also durch die erfindungsgemäß beanspruchte Minimalfläche der Segmente und deren maximale Rauigkeit erreicht werden.

Falls die Vorderfläche 4 der farbgebenden ersten Scheibe 2 mit einer optischen Interferenzschicht 9, bestehend aus einer anorganischen, chemisch inerten und harten Schicht wie zum Beispiel mit Si₃N₄, beschichtet ist, ergibt sich eine hohe Kratzfestigkeit, chemische Beständigkeit und schmutzabweisende Wirkung für das Fassadenelement 1. Durch die Verwendung von fotokatalytischen Schichten wie TiO₂ kann sich zudem ein selbstreinigender Effekt ergeben. Klimatests haben auch ergeben, dass Interferenzschichten aus Materialen wie Si₃N₄ oder TiO₂ auch die Korrosion einer gläsernen ersten Scheibe 2 durch feuchte Hitze unterbinden.

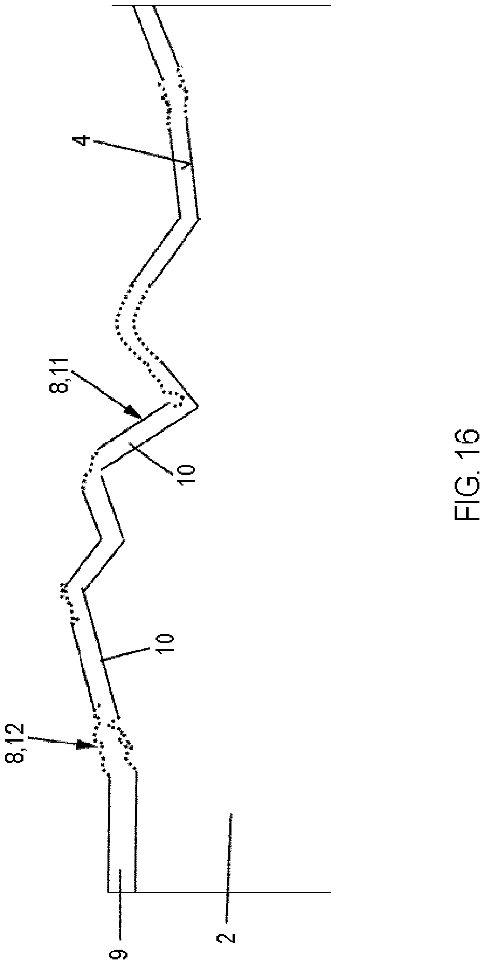

Es wird nun Bezug auf Figur 16 genommen, worin eine weitere Ausgestaltung des erfindungsgemäßen Fassadenelements 1 veranschaulicht ist, wobei wiederum lediglich die farbgebende erste Scheibe 2 gezeigt ist. Um unnötige Wiederholungen zu vermeiden, werden nur die Unterschiede zu Figur 9 beschrieben und ansonsten wird auf obige Ausführungen Bezug genommen. Bei dieser Ausgestaltung weist der strukturierte Bereich 8 der Vorderfläche 4 erste Zonen 11 und zweite Zonen 12 auf. Hierbei sind die ersten Zonen 11 so ausgebildet, dass die Segmente 10 eine mittlere Rauigkeit haben, die weniger als 15% der Schichtdicke d der optischen Interferenzschicht 9 auf der Vorderfläche 4 beträgt. In der Ausgestaltung von Figur 9 gilt dies für den gesamten strukturierten Bereich 8. Im Unterschied hierzu ist die mittlere Rauigkeit in den zweiten Zonen 12 so groß, dass eine Interferenz in der optischen Interferenzschicht 9 unterbunden wird. Beispielsweise beträgt die mittlere Rauigkeit der Segmente 10 in den zweiten Zonen 12 mehr als 50% der Schichtdicke der optischen Interferenzschicht 9. Das Fassadenelement 1 hat deshalb in den ersten Zonen 11 eine homogene Farbe, welche sich aus der Farbfilterwirkung der optischen Interferenzschicht 9 ergibt. In den zweiten Zonen 12 hat die optische Interferenzschicht 9 durch fehlende konstruktive Interferenz keinen Farbfiltereffekt und es somit liegt im Wesentlichen eine Oberfläche vor, die dem Fassadenelement ohne optischer Interferenzschicht 9 entspricht. Das Fassadenelement 1 kann somit wahlfrei in den vorgebbaren ersten Zonen 11 mit einer homogenen Farbe versehen werden. In Figur 16 sind die zweiten Zonen 12 durch eine größere Rauigkeit schematisch veranschaulicht.

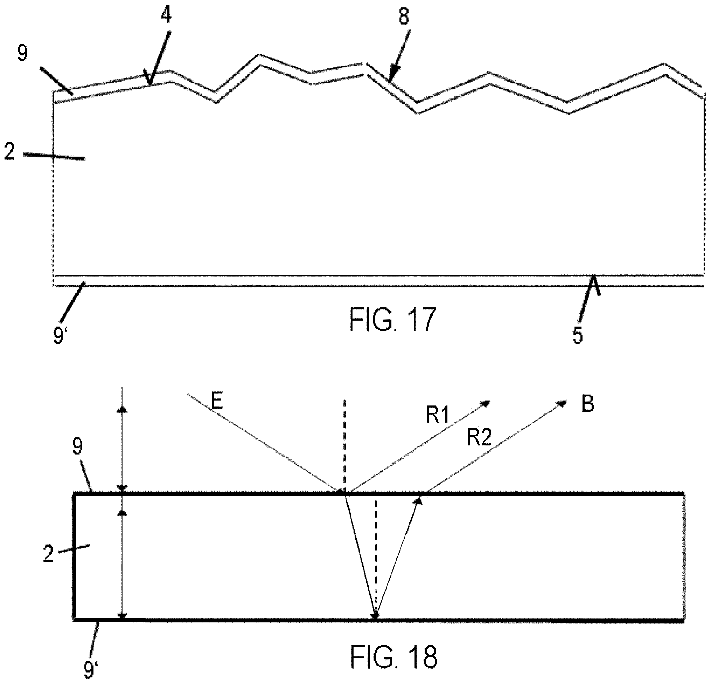

In Figur 17 ist eine weitere Ausgestaltung des erfindungsgemäßen Fassadenelements 1 veranschaulicht, wobei lediglich die farbgebende erste Scheibe 2 gezeigt ist. Um unnötige Wiederholungen zu vermeiden, werden lediglich die Unterschiede zur Ausgestaltung von Figur 9 beschrieben und ansonsten wird auf obige Ausführungen Bezug genommen. Demnach weist das Fassadenelement 1 auf der Vorderfläche 4 der farbgebenden ersten Scheibe 2 auf dem strukturierten Bereich 8 eine erste optische Interferenzschicht 9 sowie auf der Rückfläche 5 der farbgebenden ersten Scheibe 2 eine zweite optische Interferenzschicht 9' auf. Die Rückfläche 5 der farbgebenden ersten Scheibe 2 ist nicht strukturiert, d.h. weist keinen strukturierten Bereich 8 analog zur Vorderfläche 4 auf. Die Rückfläche 5 ist glatt im Rahmen der Produktionsungenauigkeiten. Die zweite optische Interferenzschicht 9' hat eine Schichtdicke d' und einen optischen Brechungsindex n', die gleich zu jenen der ersten optischen Interferenzschicht 9 sein können, jedoch nicht notwendigerweise gleich sein müssen. Durch die zweite optische Interferenzschicht 9' wird die Farbwirkung noch verstärkt. In Bezug auf die Ausgestaltung von Figur 9 gibt es hierdurch eine zweite Reflexionsquelle mit Farbfilterwirkung, da der Brechungsindex der zweiten optischen Interferenzschicht 9' zwischen der farbgebenden ersten Scheibe 2 (z.B. Glas) und der Klebeschicht 6 größer ist als jener von farbgebender erster Scheibe 2 (z.B. Glas) und Klebeschicht 6. Durch die Lichtbrechung ist der Eintrittswinkel bei der zweiten Reflexion geringer. Da das Licht in Summe dreimal eine optische Interferenzschicht passiert, ist das Licht, das den Beobachter erreicht, stärker gefiltert. Insbesondere können die Schichtdicken d, d' und die Brechungsindizes n, n' der beiden optischen Interferenzschichten 9, 9' auch voneinander deutlich verschieden sein. Bei Beschichtung mit deutlich unterschiedlichen optischen Dicken n*d bzw. n'* d' können Mischfarben generiert werden, da die erste optischen Interferenzschicht 9 dann ein anderes Reflexionsspektrum erzeugt als die zweite Interferenzschicht 9' und sich das von der zweiten Interferenzschicht 9' reflektierte Licht bei erneutem Passieren der erste Interferenzschicht 9 überlagert. So können auf sehr einfache und kostengünstige Weise farbige Fassadenelemente 1 mit einer Vielfalt von Farben und hoher Winkelstabilität erzeugt werden.

In Figur 18 ist der Strahlengang des einfallenden Lichts E und reflektierten Lichts R1, R2 stark vereinfacht veranschaulicht. In Figur 18 ist die Strukturierung der farbgebenden ersten Scheibe 2 nicht gezeigt. Dargestellt ist nur ein einziger Strahlengang, hier im Glanzwinkel bezogen auf die Ebene der farbgebenden ersten Scheibe 2. Man erkennt, dass das Licht, das die erste Interferenzschicht 9 passiert hat, in der farbgebenden ersten Scheibe 9 (z.B. Glas) gebrochen wird, ein zweites Mal an der zweiten Interferenzschicht 9' reflektiert wird und dabei durch Interferenz gefiltert wird. Beim Austritt aus der farbgebenden ersten Scheibe 2 passiert es die Interferenzschicht 9, so dass die Interferenzschichten dreimal passiert werden.

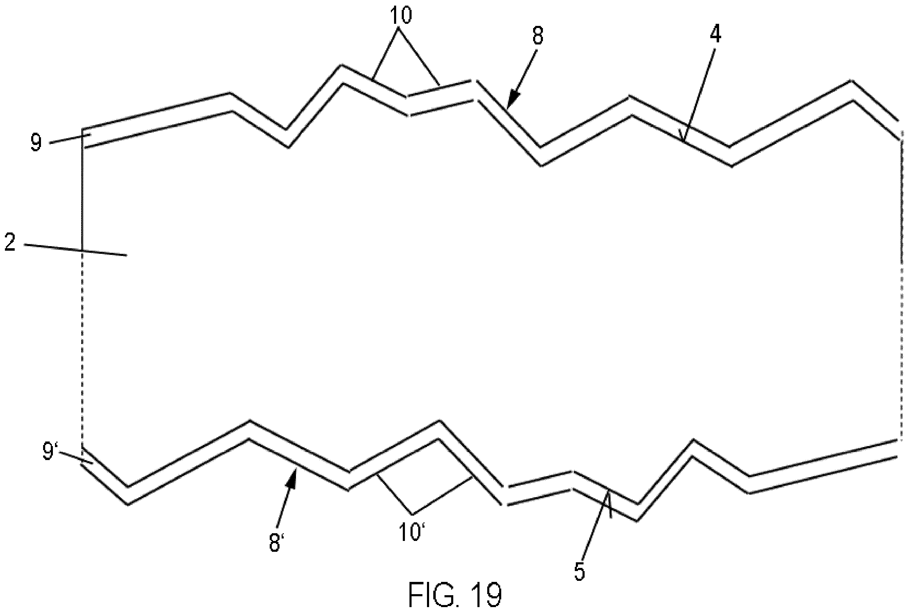

In Figur 19 ist eine weitere Ausgestaltung des erfindungsgemäßen Fassadenelements 1 veranschaulicht, wobei lediglich die farbgebende erste Scheibe 2 gezeigt ist. Um unnötige Wiederholungen zu vermeiden, werden lediglich die Unterschiede beschrieben und ansonsten wird auf obige Ausführungen Bezug genommen. Demnach weist das Fassadenelement 1 auf der Vorderfläche 4 der farbgebenden ersten Scheibe 2 einen ersten strukturierten Bereich 8 und auf der Rückfläche 5 der farbgebenden ersten Scheibe 2 einen zweiten strukturierten Bereich 8' auf, wobei auf dem ersten strukturierten Bereich 8 eine erste optische Interferenzschicht 9 und auf dem zweiten strukturierten Bereich 8' eine zweite optische Interferenzschicht 9' angeordnet ist. Die beiden strukturierten Bereiche 8, 8' können gleich oder verschieden ausgebildet sein. Ebenso können die beiden optischen Interferenzschichten 9, 9' gleich oder verschieden ausgebildet sein, wobei insbesondere die Schichtdicken d, d' und die Brechungsindizes n, n' der beiden optischen Interferenzschichten 9, 9' voneinander verschieden sein können. Wenn eine gleiche optische Dicke n*d für die beiden optischen Interferenzschichten 9, 9' gewählt wird, kann die Farbe des Fassadenelements 1 verstärkt werden. Bei Beschichtung mit deutlich unterschiedlichen optischen Dicken können Mischfarben generiert werden.

Diesen Ausgestaltungen ist gemeinsam, dass bereits beim Auftreffen des Lichts auf die strukturierte Vorderfläche mit Interferenzschicht durch Reflexion und Interferenz eine Farbe mit hohen Intensität und geringer Winkelabhängigkeit auch außerhalb des Glanzwinkels entsteht. Die zusätzlichen Interferenzschichten und/oder Strukturierungen auf der Rückfläche können diese Wirkung noch verstärken.

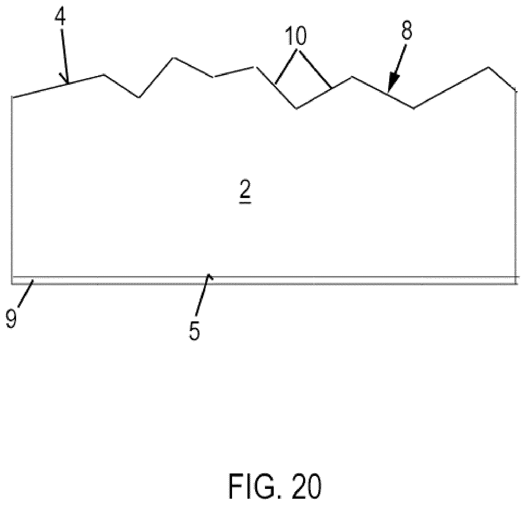

In Figur 20 ist anhand eines vergrößerten Ausschnitts der farbgebenden ersten Scheibe 2 des Fassadenelements 1 eine weitere Ausgestaltung des erfindungsgemäßen Fassadenelements 1 veranschaulicht. Um unnötige Wiederholungen zu vermeiden, werden lediglich die Unterschiede beschrieben und ansonsten wird auf obige Ausführungen Bezug genommen. Demnach ist die Vorderfläche 4 der farbgebende ersten Scheibe 2 in einem Bereich 8 strukturiert, welcher sich im vorliegenden Beispiel über die komplette Vorderfläche 4 erstreckt, d.h. Vorderfläche 4 und strukturierter Bereich 8 sind identisch. Unmittelbar auf der Rückfläche 5 der farbgebenden ersten Scheibe 2 ist eine optische Interferenzschicht 9 angeordnet. Die Rückfläche 5 weist keine Strukturierung auf und ist im Rahmen der Produktionsungenauigkeiten glatt. Auf der Vorderfläche 4 befindet sich keine optische Interferenzschicht. Für die Segmente 10 des strukturierten Bereichs 8 der Vorderfläche 4 des Fassadenelements 1 von Figur 20 gibt es keine Bedingung für die Rauigkeit.

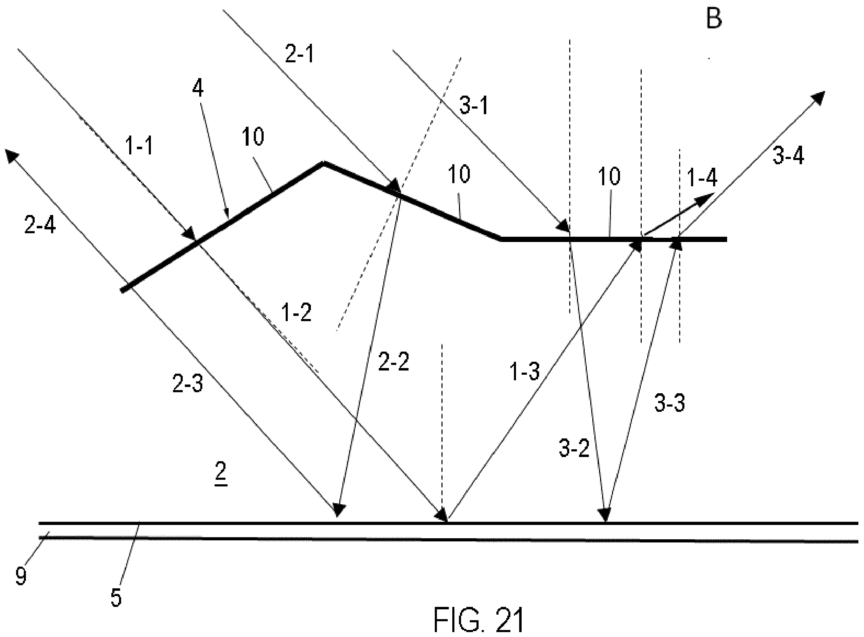

Anhand von Figur 21 wird die Funktion der strukturierten Vorderfläche 4 in Kombination mit der innenseitigen Interferenzschicht 9 gemäß der Ausgestaltung von Figur 20 näher erläutert. Darin gezeigt sind beispielhaft verschiedene Lichtwege für verschieden geneigte Segmente 10 der farbgebenden ersten Scheibe 2. Beispielhaft sind drei Segmente 10 gezeigt, wobei das rechte Segment 10 parallel zur Ebene der farbgebenden ersten Scheibe 2 liegt und die beiden anderen Segmente 10 einen von Null verschiedenen Winkel zur Ebene der farbgebenden ersten Scheibe 2 haben. Die Reflexion der Lichtstrahlen an der Interferenzschicht 9 ist vereinfacht dargestellt. Die Reflexion an der Interferenzschicht 9 wurde bereits erläutert. In Figur 21 sind die Lichtwege für drei Lichtstrahlen gezeigt, die jeweils in einem selben Winkel zur Normalen der Ebene der farbgebenden ersten Scheibe 2 auf die verschieden geneigten Segmente 10 der Vorderfläche 4 der farbgebenden ersten Scheibe 2 treffen. Das jeweilige Lot auf die Segmente 10 ist gestrichelt eingezeichnet. Aufgrund der verschieden geneigten Segmente 10 werden die Lichtstrahlen in verschiedener Weise reflektiert. Ein erster Lichtstrahl 1-1 trifft auf ein Segment 10, quert als gebrochener Lichtstrahl 1-2 die farbgebende erste Scheibe 2, wird als Lichtstrahl 1-3 von der Interferenzschicht 9 (im Glanzwinkel) reflektiert, und tritt als gebrochener Lichtstrahl 1-4 von der farbgebenden ersten Scheibe 2 zur äußeren Umgebung hin aus. Der letztlich von der farbgebenden ersten Scheibe 2 reflektierte Lichtstrahl 1-4 weist einen anderen Winkel zur Normalen auf die Ebene der farbgebenden ersten Scheibe 2 auf als der einfallende Lichtstrahl 1-1, so dass keine Reflexion im Glanzwinkel sondern Streuung vorliegt. In entsprechender Weise trifft ein zweiter Lichtstrahl 2-1 auf ein anderes Segment 10, quert als gebrochener Lichtstrahl 2-2 die farbgebende erste Scheibe 2, wird als Lichtstrahl 2-3 von der Interferenzschicht 9 reflektiert, und tritt als gebrochener Lichtstrahl 2-4 von der farbgebenden ersten Scheibe 2 zur äußeren Umgebung hin aus. Der reflektierte Lichtstrahl 2-4 tritt annähernd entgegen der Einfallsrichtung des Lichtstrahls 2-1 von der farbgebenden ersten Scheibe 2 aus, was ebenfalls ein Streuvorgang und keine Reflexion im Glanzwinkel ist. Ein dritter Lichtstrahl 3-1 trifft auf ein weiteres Segment 10, quert als gebrochener Lichtstrahl 3-2 die farbgebende erste Scheibe 2, wird als Lichtstrahl 3-3 von der Interferenzschicht 9 reflektiert, und tritt als gebrochener Lichtstrahl 3-4 von der farbgebenden ersten Scheibe 2 zur äußeren Umgebung hin aus. Dieses Segment 10 liegt parallel zur Ebene der farbgebenden ersten Scheibe 2, so dass der Lichtstrahl 2-4 im Glanzwinkel reflektiert wird. Wesentlich hierbei ist, dass durch jene Segmente 10, die zur Ebene der farbgebenden ersten Scheibe 2 geneigt sind, aufgrund der Brechung am jeweiligen Segment 10 und anschließende Reflexion an der Grenzfläche mit Interferenzschicht 9 und weiterer Brechung an der strukturierten Oberfläche insgesamt eine starke Reflexion auch außerhalb des Glanzwinkels (bezogen auf die Ebene der farbgebenden ersten Scheibe 2) auftritt, so dass in Kombination mit der Interferenzschicht 9 eine homogene Farbwirkung des reflektierten Lichts erreicht wird.

In Figur 21 ist beispielhaft die Position eines Betrachters B dargestellt, der sich außerhalb des Glanzwinkels befindet. Aufgrund der relativ stark (diffus) streuenden farbgebenden ersten Scheibe 2 mit äußerer Strukturierung und innen liegender Interferenzschicht finden sich für verschiedene Betrachtungswinkel außerhalb des Glanzwinkels meist passende Lichtwege, die die Interferenzschicht passiert haben. Hierdurch ergibt sich ein Farbeindruck, der weitaus weniger richtungsabhängig ist als bei herkömmlichen Modulen ohne strukturierten Bereich 8.

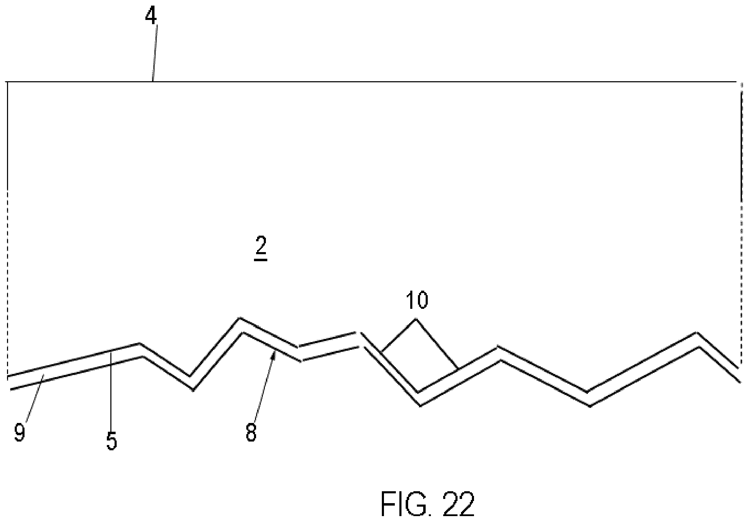

Es wird nun Bezug auf Figur 22 genommen, worin eine weitere Ausgestaltung des erfindungsgemäßen Fassadenelements 1 veranschaulicht ist, wobei lediglich die farbgebende erste Scheibe 2 gezeigt ist. Um unnötige Wiederholungen zu vermeiden, werden nur die Unterschiede beschrieben und ansonsten wird auf obige Ausführungen Bezug genommen. Demnach weist das Fassadenelement 1 auf der Rückfläche 5 der farbgebenden ersten Scheibe 2 einen strukturierten Bereich 8 auf, wobei auf dem strukturierten Bereich 8 eine optische Interferenzschicht 9 angeordnet ist. Die optische Interferenzschicht 9 ist dünn und folgt der Oberfläche des strukturierten Bereichs 8. Der strukturierte Bereich 8 und die optische Interferenzschicht 9 können jeweils analog zu den bisherigen Ausgestaltungen ausgebildet sein. Die Vorderfläche 4 der farbgebenden ersten Scheibe 2 weist keinen strukturierten Bereich 8 auf und ist im Rahmen der Produktionsungenauigkeiten glatt. Ferner ist keine optische Interferenzschicht auf der Vorderfläche 4 angeordnet. Im Unterschied zu den Segmenten 10 des strukturierten Bereichs 8 der Vorderfläche 4 befindet sich auf dem strukturierten Bereich 8 der Rückfläche 5 die optische Interferenzschicht 9, so dass die Segmente 10 die Bedingung zu erfüllen haben, wonach die Segmente 10 des strukturierten Bereichs 8 der Rückfläche 5 jeweils eben sind, eine Segmentfläche von mindestens 1 µm² haben und eine mittlere Rauigkeit von weniger als 15% einer Schichtdicke der optischen Interferenzschicht 9 auf der Rückfläche 5 aufweisen.

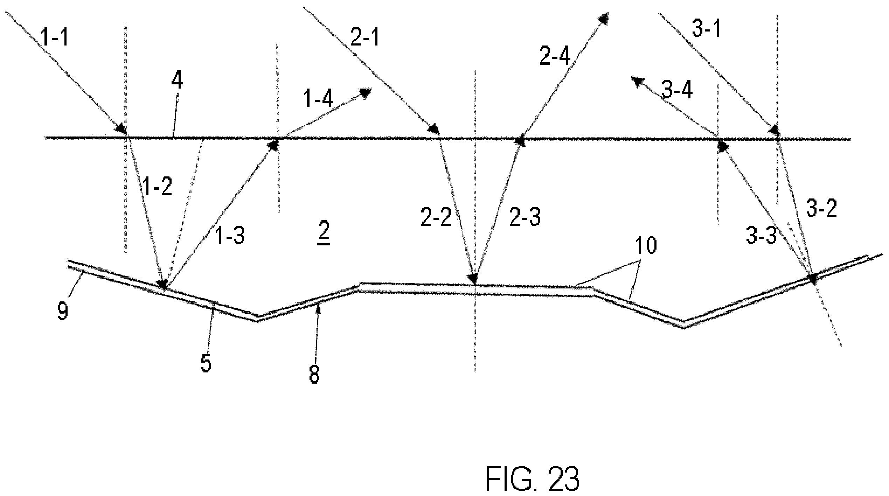

In Figur 23 sind beispielhaft drei verschiedene Lichtwege gezeigt. Die Reflexion der Lichtstrahlen an der Interferenzschicht 9 ist wiederum vereinfacht dargestellt. Aufgrund der verschieden geneigten Segmente 10 werden die Lichtstrahlen verschieden von der farbgebenden ersten Scheibe 2 reflektiert. Ein erster Lichtstrahl 1-1 trifft auf die Vorderfläche 4 der farbgebenden ersten Scheibe 2, quert als gebrochener Lichtstrahl 1-2 die farbgebende erste Scheibe 2, wird als Lichtstrahl 1-3 von einem zur Ebene der farbgebenden ersten Scheibe 2 geneigten Segment 10 reflektiert, und tritt als gebrochener Lichtstrahl 1-4 von der farbgebenden ersten Scheibe 2 zur äußeren Umgebung hin aus. In entsprechender Weise trifft ein zweiter Lichtstrahl 2-1 auf die Vorderfläche 4 der farbgebenden ersten Scheibe 2, quert als gebrochener Lichtstrahl 2-2 die farbgebende erste Scheibe 2, wird als Lichtstrahl 2-3 von einem zur Ebene der farbgebenden ersten Scheibe 2 parallelen Segment 10 reflektiert und tritt als gebrochener Lichtstrahl 2-4 von der farbgebenden ersten Scheibe 2 zur äußeren Umgebung hin aus. In entsprechender Weise trifft ein dritter Lichtstrahl 3-1 auf die Vorderfläche 4 der farbgebenden ersten Scheibe 2, quert als gebrochener Lichtstrahl 3-2 die farbgebende erste Scheibe 2, wird als Lichtstrahl 3-3 von einem zur Ebene der farbgebenden ersten Scheibe 2 geneigten Segment 10 reflektiert, und tritt als gebrochener Lichtstrahl 3-4 von der farbgebenden erste Scheibe 2 zur äußeren Umgebung hin aus. Lediglich für das mittlere Segment 10 ist für den einfallenden Lichtstrahl 2-1 und ausfallenden Lichtstrahl 2-4 die Bedingung Einfallswinkel = Ausfallswinkel, d.h. Reflexion im Glanzwinkel, erfüllt. Die anderen Lichtstrahlen werden von den Segmenten 10 jeweils im lokalen Glanzwinkel reflektiert, welcher jedoch nicht dem Glanzwinkel der Ebene der farbgebenden ersten Scheibe 2 entspricht, so dass eine relativ starke Streuung auftritt. In Verbindung mit der optischen Interferenzschicht 9 kann eine wenig richtungsabhängige, homogene Farbwirkung für das Fassadenelement 1 erzielt werden.

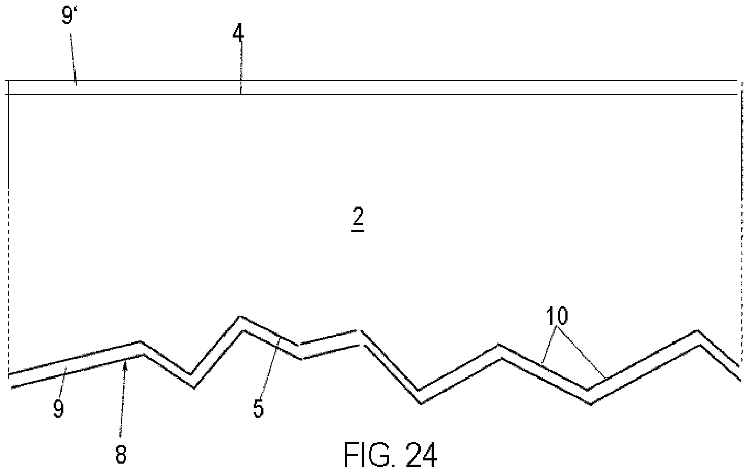

In Figur 24 ist eine weitere Ausgestaltung des erfindungsgemäßen Fassadenelements 1 veranschaulicht, wobei nur die farbgebende erste Scheibe 2 gezeigt ist. Um unnötige Wiederholungen zu vermeiden, werden lediglich die Unterschiede beschrieben und ansonsten wird auf obige Ausführungen Bezug genommen. Demnach weist das Fassadenelement 1, neben der optischen Interferenzschicht 9 auf dem strukturierten Bereich 8 der Rückfläche 5 der farbgebenden ersten Scheibe 2 eine weitere optische Interferenzschicht 9' unmittelbar auf der Vorderfläche 4 der farbgebenden ersten Scheibe 2 auf. Die Vorderfläche 4 ist nicht strukturiert, d.h. weist keinen strukturierten Bereich 8 analog zur Rückfläche 5 auf. Vielmehr ist die Vorderfläche 4 glatt im Rahmen der Produktionsungenauigkeiten. Die beiden Interferenzschichten 9, 9' können einen gleichen oder verschiedenen optischen Brechungsindex sowie eine gleiche oder verschiedene Schichtdicke haben. Wenn eine gleiche optische Dicke n*d für die beiden optischen Interferenzschichten 9, 9' gewählt wird, kann die Farbe des Solarmoduls 1 verstärkt werden, da das den Beobachter erreichende Licht in Summe dreimal eine optische Interferenzschicht passiert und deshalb stärker gefiltert ist. Bei Beschichtung mit deutlich unterschiedlichen optischen Dicken können Mischfarben generiert werden.

Falls die Vorderfläche 4 der farbgebenden ersten Scheibe 2 mit einer optischen Interferenzschicht 9' beschichtet wird, die aus einer anorganischen, chemisch inerten und harten Schicht wie zum Beispiel Si₃N₄ besteht, ergibt sich eine hohe Kratzfestigkeit, chemische Beständigkeit und schmutzabweisende Wirkung für das Fassadenelement 1. Durch die Verwendung von fotokatalytischen Schichten wie TiO₂ kann sich zudem ein selbstreinigender Effekt ergeben.

Eine solche auf der Vorderfläche 4 angeordnete zusätzliche Schicht kann auch eine dünne Antireflexschicht sein, welche einen optischen Brechungsindex aufweist, der kleiner ist als jener der farbgebenden ersten Scheibe 2. Dadurch wird die im Wesentlichen weiße Reflexion der farbgebenden ersten Scheibe 2 (z.B. Glas) unterdrückt und der Sättigungsgrad der Farben steigt.

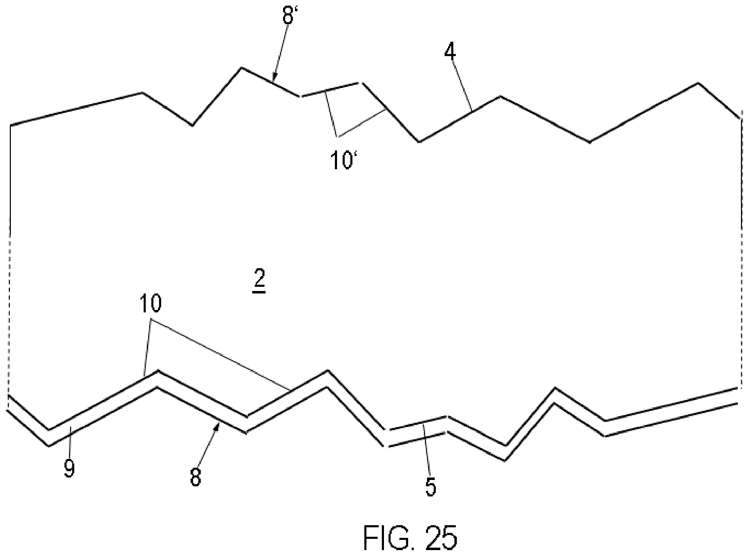

In Figur 25 ist eine weitere Ausgestaltung des erfindungsgemäßen Fassadenelements 1 veranschaulicht, wobei nur die farbgebende erste Scheibe 2 gezeigt ist. Um unnötige Wiederholungen zu vermeiden, werden lediglich die Unterschiede beschrieben und ansonsten wird auf obige Ausführungen Bezug genommen. Demnach weist die Rückfläche 5 der farbgebenden ersten Scheibe 2 des Fassadenelements 1 einen strukturierten Bereich 8 auf, auf dem eine optische Interferenzschicht 9 angeordnet ist. Weiterhin weist auch die Vorderfläche 4 der farbgebenden erste Scheibe 2 einen strukturierten Bereich 8' auf. Auf der Vorderfläche 4 ist keine optische Interferenzschicht angeordnet. Die beiden strukturierten Bereiche 8, 8' können gleich oder voneinander verschieden sein. Im Ausführungsbeispiel von Figur 25 haben alle Segmente 10 einen Neigungswinkel von maximal 45°. Im Unterschied zu den Segmenten 10 des strukturierten Bereichs 8 der Rückfläche 5, gibt es für die Segmente 10' des strukturierten Bereichs 8' der Vorderfläche 4 des Fassadenelements 1 von Figur 25 keine Bedingung für die Rauigkeit.

Eine solche auf der Vorderfläche 4 angeordnete zusätzliche Schicht kann auch eine dünne, farbneutrale Antireflexschicht sein, welche einen optischen Brechungsindex aufweist, der kleiner ist als jener der farbgebenden ersten Scheibe 2. Dadurch wird die im Wesentlichen weiße Reflexion der farbgebenden ersten Scheibe 2 (z.B. Glas) unterdrückt und der Sättigungsgrad der Farben steigt. Eine zusätzliche, auf der Vorderfläche 4 angeordnete Schicht kann aber auch den gleichen optischen Brechungsindex wie die farbgebende erste Scheibe 2 aufweisen. In diesem Fall dient die Schicht nur dem Schutz der farbgebenden ersten Scheibe 2 vor Feuchte und andern korrosiven Bestandteilen der Luft. Es hat sich gezeigt, dass durch Ätzen hergestellte satinierte Gläser empfindlicher gegenüber feuchter Hitze sind als plane oder gewalzte Gläser. Im Falle von geätztem Kalknatronglas kann die zusätzliche Schicht zum Beispiel eine dünne gesputterte SiO₂-Schicht sein.

Bei diesen Ausgestaltungen muss das Licht mindestens einmal die farbgebende erste Scheibe passieren und muss an der innenliegenden Interferenzschicht reflektiert werden, um nach Austritt aus der Vorderfläche die gewünschte Farbigkeit mit der verbesserten Winkelstabilität zu erreichen.

Grundsätzlich kann das Fassadenelement 1 durch eine beliebige geeignete Befestigungstechnik, beispielsweise Rückseitenschienen, gebohrte Punkthalter, Klemmleisten usw. an einer Fassade montiert werden. Häufig kommen in vorgehängt-hinterlüfteten Fassaden Einhängesysteme zum Einsatz, bei denen die Fügeverbindung über einen Formschluss realisiert wird.

In Figur 26 ist die Messanordnung zur Bestimmung der diffusen Streuung des erfindungsgemäßen Fassadenelements 1 mit einem kommerziell verfügbaren Mehrwinkel-Farbmessgerät 17 veranschaulicht (Mehrwinkel-Farbmessung). Der nicht näher dargestellte strukturierte Bereich 8 erstreckt sich über die komplette farbgebende erste Scheibe 2 (z.B. Glas). Hierbei wird ein Lichtstrahl auf die Vorderfläche 4 des zu charakterisierenden Fassadenelements 1 unter verschiedenen Einfallswinkeln gerichtet und das gestreute bzw. reflektierte Licht aus verschiedenen Beobachtungswinkeln, beispielsweise 15° oder 45° zur Oberflächennormalen der Ebene der farbgebenden ersten Scheibe 2, spektral vermessen. Unter der farbgebenden ersten Scheibe 2 befindet sich ein opakes Rückseitenelement 14, das hier beispielsweise als eine schwarze, nicht glänzende Schicht (z.B. angebunden mit einer Flüssigkeit mit Brechungsindex bei etwa 1.5) ausgebildet ist. Mit dem Mehrwinkel-Farbmessgerät 17 kann man die Helligkeit im L-ab System bei D65 Norm Beleuchtung und 10° Öffnungswinkel bestimmen. Es hat sich gezeigt, dass eine gute Winkelstabilität (d.h. geringe Winkelabhängigkeit des gestreuten Lichts) gegeben ist, wenn sowohl bei 45° als auch bei 15° Beobachtungswinkel und bei einem Einfallswinkel von 45°, jeweils gemessen vom Glanzwinkel, noch mindestens eine Helligkeit von L = 10, bevorzugt L = 15 und noch besser L= 20 vorliegt. Durch den mindestens einen strukturierten Bereich 8 von Vorderfläche 4 und/oder Rückfläche 5 der Farbgebende erste Scheibe 2 kann sowohl bei 45° als auch bei 15° Beobachtungswinkel und bei einem Einfallswinkel von 45°, jeweils gemessen vom Glanzwinkel (in beiden Richtungen), mindestens eine Helligkeit von L = 10 erreicht werden. Die Gradangaben sind folgendermaßen zu verstehen: Reflexionswinkel (bezogen auf Oberflächennormale/Einfallswinkel (bezogen auf Glanzwinkel). Beispielsweise fällt bei einem Beobachtungswinkel von 45° (gemessen relativ zur Oberflächennormalen) und einem Einfallswinkel von 45° (gemessen vom Glanzwinkel) der einfallende Stahl genau senkrecht zur Oberfläche ein (45/45). Bei einem Beobachtungswinkel von 15° und einem Einfallswinkel von 45° liegt die Einfallsrichtung 30° von der Oberflächennormalen auf der gleichen Seite wie die Beobachtungsrichtung (15/45). Das Mehrwinkel-Farb-Messgerät 20 ist bei einem Beobachtungswinkel von 45° bzw. 15° relativ zur Oberflächennormalen positioniert. Bei allen Ausgestaltungen des erfindungsgemäßen Fassadenelements mit fotovoltaisch aktivem Rückseitenelement befindet sich der elektrisch aktive Bereich in vorteilhafter Weise hinter der schützenden Außenhaut der Verbundscheibe aus erster Scheibe und zweiter Scheibe. Optisch störende Komponenten bleiben hinter der opaken Maskierungsschicht verborgen werden. Mechanisch auftragende Komponenten, wie Anschlussdosen und Kabel, können an ihrer üblichen Position hinter der Rückseite des Solarmoduls bleiben. Die Fertigung der Solarmodule bleibt weitgehend unverändert, wobei lediglich die Lamination des Frontglases entfällt oder das fertige Solarmodul mit einer weiteren Scheibe (farbgebendes Glaselement oder mechanisch unterstützendes Glaselement) laminiert wird. Rahmen oder Backrails entfallen. Es können mehrere Solarmodule auf dem größeren Verbundelement auflaminiert und über Kabel verbunden werden, wenn das Paneel, die Ausfachung oder das Fensterelement Flächen-Dimensionen wie im Hochhausbau erreichen soll.

In den Ausgestaltungen der Figuren 3 und 4 ist die Farbgebung stärker, da sich das farbgebende Glaselement auf der Außenseite der Fassade befindet. Bei der Ausgestaltung von Figur 5 liegt das farbgebende Glaselement auf der Innenseite und ist daher geschützter. Wenn nur ein Solarmodul passender Größe verwendet werden soll, kann dieses auch ein Solarmodul aus der Serienfertigung sein, das bereits mit einem texturierten und beschichteten Glaselement gefertigt wurde. Wenn mehrere Solarmodule in eine Ausfachung eingebaut werden sollen, dann ist es günstiger, ein großes gestaltendes Glaselement zu verwenden, da dann die Zwischenräume mit opaken Schichten abgedeckt werden können.

Durch den modularen Aufbau werden die unterschiedlichen Funktionen getrennt und jedes Glaselement kann für sich optimiert werden: das farbgebende Glaselement wird optimiert im Hinblick auf die gewünschte Farbgebung bei möglichst geringem Wirkungsgradverlust, das mechanisch unterstützende Glaselement wird so dimensioniert und nachbehandelt (VHF, ESG), dass es die mechanischen Anforderungen bzgl. Eigengewicht des Verbunds bezüglich Windlast erfüllt. Das Solarmodul kann weitgehend aus der Standardproduktion genommen werden.

Die erfindungsgemäßen Varianten gemäß Figur 3 und 5 haben den Vorteil, dass Trägersubstrate mit Solarzellen in hinterlüfteten Fassadenelementen, Pfosten-Riegelkonstruktionen oder Fensterelemente integriert werden können. Das farbgebende Glaselement kann dabei jeweils unabhängig von der erforderlichen Dicke des mechanisch unterstützenden Glaselements produziert werden. Das mechanisch unterstützende Glaselement wird nach erforderlicher Baustatik (Gesamtgewicht des Verbundelements und Windlasttragfähigkeit) dimensioniert.

Bei der Variante von Figur 4 können die Fertigungsprozesse, aber auch bestimmte Gewährleistungen vorteilhaft nach Lieferkette getrennt werden. Der Solarmodulhersteller liefert ein elektrisch vollständig geprüftes und versiegeltes Solarmodul.

Zwar wird die Modulleistung durch Auflaminieren auf ein dickeres Glas etwas reduziert, jedoch kann durch Verwendung von Weißglas dies auf vernachlässigbare Werte minimiert werden. Bei Weißglas mit geringem Eisenanteil verringert sich die Transmission zwischen 4 mm und 12 mm Glasdicke nur von 91% auf 90%.

Das farbige Fassadenelement aus farbgebendem Glaselement, mechanisch unterstützendem Glaselement mit oder ohne fotovoltaisch aktivem Rückseitenelement kann mit verschiedenen gängigen Ausführungsformen für vorgehängte hinterlüftete Fassaden, Elementfassaden oder Pfostenriegelfassaden oder großen Fensterelementen kombiniert werden. Bei einer Pfosten-Riegel- oder Element-Fassade oder der Verwendung als Fensterelement können sich optional mindestens eine weitere Glasscheibe oder eine andere Abdeckung aus einem anderen Material hinter der Rückseite der Solarmodule befinden, die das Fassadenelement zur Raumseite abschließen. Die Anschlussdose und die Kabel befinden sich dann zwischen dem Solarmodul und der raumseitigen Abdeckung. Wenn die raumseitige Abdeckung eine Glasscheibe ist, können beide zusammen mit einem geeigneten Rahmen und Abdichtungen nach dem Stand der Technik als Isolierglas, Fassadenelement oder als Fensterelement mit Gasfüllung ausgestaltet werden. Beispielhaft ist das in Figur 8 gezeigt. Die äußere Scheibe eines konventionellen Isolierglasfensters wird dabei durch die farbige Verbundscheibenstruktur ersetzt. Die Kabel müssen dann aus dem Rahmen herausgeführt werden. Auch die Verwendung mit raumseitig zwei weiteren Scheiben als Dreifachverglasung ist möglich.

Die Verbundscheibenstruktur und die raumseitige Abdeckung sind mit geeigneten Abstandshaltern (wegen Anschlussdose und Kabel) und klebenden Abdichtungen ohne Rahmen verbunden und werden zusammen als Paket mit Linienhalterung oder Punkthalterungen mit dem Pfosten-Riegel Tragwerk verbunden. Die Kabel müssen durch die Abstandshalter oder durch die raumseitige Abdeckung herausgeführt werden. Zwischen der raumseitigen Abdeckung und dem Solarmodul kann sich auch ein wärmedämmendes Material (geschäumte Kunststoffe wie Polystyrol (Styropor), Mineralfasern, Glaswolle u.a.) befinden. Die raumseitige Abdeckung kann auch eingehängt werden an Befestigungen, die sich im tragenden Glaselement befinden. Dann kann die raumseitige Abdeckung für Wartungsarbeiten entfernt werden.

Bei einem Fensterelement mit Solarmodul kann das farbgebende Glaselement auch deutlich kleiner als das mechanisch unterstützende Glaselement gewählt werden. Die Ausfachung oder das Fensterelement besteht dann aus einem transparenten Bereich (Fenster) und einem opaken farbigen Bereich, der entweder fotovoltaisch aktiv ist oder ganz oder teilweise auch passiv sein kann, wie in Figur 7 gezeigt.

Das Fassadenelement kann auch als Paneel einer vorgehängten hinterlüfteten Fassade verwendet werden. Im Unterschied zum derzeit verwendeten Modul mit Backrail kann die Verbundscheibenstruktur durch die mechanische Verstärkung mittels des mechanisch unterstützenden Glaselements ohne Backrail in gängige Konstruktionen für Glas integriert werden. Dafür können Linienhalterungen, Punkthalterungen oder mechanische Klammern verwendet werden. Das Solarmodul und das farbgebende Glaselement tragen dabei nur in geringem Maße zur Erreichung der Wlndlasttragfähigkeit bei. Der wesentliche mechanische Kern ist das mechanisch unterstützende Glaselement.

Wie sich aus vorstehender Erfindungsbeschreibung ergibt, stellt die Erfindung ein verbessertes Fassadenelement zur Verfügung, das eine sehr homogene, intensive Farbe, bei geringer oder fehlender Richtungsabhängigkeit hat. Das Fassadenelement kann kosteneffizient in verschiedenen Formen und Größen hergestellt werden und in einfacher Weise in eine Fassade integriert werden. Besonders vorteilhaft weist das Fassadenelement eine besonders hohe mechanische Festigkeit auf, so dass es auch höheren Windlasten standhalten kann. Die Erfindung stellt somit eine Neuerung zur Verfügung, die in der Praxis des Fassadenbaus erhebliche Vorteile mit sich bringt.

### Bezugszeichenliste

- 1: Fassadenelement
- 2: erste Scheibe
- 3: zweite Scheibe
- 4, 4': Vorderfläche
- 5, 5': Rückfläche
- 6: Klebeschicht
- 7: Kontaktfläche
- 8, 8': strukturierter Bereich
- 9, 9': optische Interferenzschicht
- 10, 10': Segment
- 11: erste Zone
- 12: zweite Zone
- 13, 13': Zwischenschicht
- 14: Rückseitenelement
- 15, 15': Verbundscheibe
- 16: Trägersubstrat
- 17: Mehrwinkelfarbmessgerät
- 18: Solarzellen
- 19: Maskierungsschicht
- 20: Solarmodul
- 21: Anschlussleitung
- 22: Anschlussdose
- 23: Fenster
- 24: Abstandhalter
- 25: Isolierglasscheibe

- Vorderseite: V
- Rückseite: R
- Äußere Umgebung: U

## Patentansprüche

1. Fassadenelement (1), welches eine farbgebende transparente oder semi-transparente erste Scheibe (2) und eine mechanisch unterstützende transparente zweite Scheibe (3), die durch eine Zwischenschicht (13) fest miteinander verbunden sind, umfasst, wobei die erste Scheibe (2) eine lichteinfallseitig angeordnete Vorderfläche (4) und eine gegenüberliegende Rückfläche (5) aufweist, wobei mindestens eine Fläche (4, 5), gewählt aus Vorder- und Rückfläche, mindestens einen strukturierten Bereich (8, 8') aufweist, und wobei auf mindestens einer Fläche (4, 5), gewählt aus Vorder- und Rückfläche, mindestens eine optische Interferenzschicht (9, 9') zur Reflexion von Licht innerhalb eines vorgegebenen Wellenlängenbereichs angeordnet ist,
**dadurch gekennzeichnet, dass** der mindestens eine strukturierte Bereich (8, 8') folgende Merkmale aufweist:
- senkrecht zur Ebene der ersten Scheibe (2) ein Berge und Täler aufweisendes Höhenprofil, wobei ein mittlerer Höhenunterschied zwischen den Bergen und Tälern mindestens 2 µm beträgt,
- mindestens 50% des strukturierten Bereichs setzt sich aus Segmenten zusammen, die zur Ebene der ersten Scheibe (2) geneigt sind, wobei, bezogen auf die Ebene der ersten, mindestens 20% der Segmente einen Neigungswinkel im Bereich von größer als 0° bis maximal 15° und mindestens 30% der Segmente einen Neigungswinkel im Bereich von größer als 15° bis maximal 45° haben, wobei
- die Segmente jeweils eben sind und eine Segmentfläche von mindestens 1 µm² haben, wobei die Segmente jeweils eine mittlere Rauigkeit von weniger als 15% einer Schichtdicke der mindestens einen optischen Interferenzschicht haben.

2. Fassadenelement (1) nach Anspruch 1, bei welcher die zweite Scheibe (3)
i) dicker, oder
ii) dünner ist als die erste Scheibe (2).

3. Fassadenelement (1) nach Anspruch 1 oder 2, bei welcher
i) die erste Scheibe (2), oder
ii) die zweite Scheibe (3)
lichteinfallseitig der Zwischenschicht (13) angeordnet ist.

4. Fassadenelement (1) nach einem der Ansprüche 1 bis 3, bei welcher auf deren Rückseite (R) mindestens ein flächiges Rückseitenelement (14) angebracht ist.

5. Fassadenelement (1) nach Anspruch 4, bei welcher das mindestens eine flächige Rückseitenelement (14) zur photovoltaischen Energieerzeugung geeignet ist.

6. Fassadenelement (1) nach Anspruch 5, bei welcher das zur photovoltaischen Energieerzeugung geeignete Rückseitenelement (14) ein Trägersubstrat (16) mit Solarzellen (18) umfasst, wobei das Trägersubstrat (16), ohne zwischenliegende Scheibe, mit der ersten Scheibe (2) oder zweiten Scheibe (3) durch eine weitere Zwischenschicht (13') fest verbunden ist.

7. Fassadenelement (1) nach Anspruch 5 oder 6, bei welcher die erste Scheibe (2) oder die zweite Scheibe (3) eine Deckscheibe eines vorgefertigten Solarmoduls (20) ist.

8. Fassadenelement (1) nach einem der Ansprüche 5 bis 7, bei welcher das flächige Rückseitenelement (14), bezogen auf die Ebene der frontseitigen Scheibe (2, 3), kleiner ist als die frontseitigen Scheibe (2, 3).

9. Fassadenelement (1) nach Anspruch 4, bei welcher das mindestens eine Rückseitenelement ausgebildet ist als:
- eine Beschichtung, insbesondere opake Beschichtung, der rückseitig angeordneten ersten oder zweiten Scheibe (2, 3),
- eine Folie, insbesondere opake Folie, die durch ein transparentes Klebemittel, insbesondere eine transparente Klebefolie, welche mit der rückseitig angeordneten ersten oder zweiten Scheibe (2, 3) fest verbunden ist, oder
- ein starrer Körper, insbesondere opaker starrer Körper der durch ein transparentes Klebemittel, insbesondere eine transparente Klebefolie, welcher mit der rückseitig angeordneten ersten oder zweiten Scheibe (2, 3) fest verbunden ist.

10. Fassadenelement (1) nach einem der Ansprüche 1 bis 9, bei welcher die Vorderfläche (4) der ersten Scheibe (2) mindestens einen strukturierten Bereich (8) aufweist, auf dem eine optische Interferenzschicht (9) zur Reflexion von Licht innerhalb eines vorgegebenen Wellenlängenbereichs angeordnet ist.

11. Fassadenelement (1) nach Anspruch 10, bei welcher
i) die Rückfläche (5) der ersten Scheibe (2) keinen strukturierten Bereich und keine optische Interferenzschicht aufweist, oder
ii) die Rückfläche (5) der ersten Scheibe (2) keinen strukturierten Bereich aufweist und auf der Rückfläche (5) der ersten Scheibe (2) eine weitere optische Interferenzschicht (9') zur Reflexion von Licht innerhalb eines vorgegebenen Wellenlängenbereichs angeordnet ist, oder
iii) die Rückfläche (5) der ersten Scheibe (2) mindestens einen strukturierten Bereich aufweist (8'), auf dem eine optische Interferenzschicht (9') zur Reflexion von Licht innerhalb eines vorgegebenen Wellenlängenbereichs angeordnet ist.

12. Fassadenelement (1) nach einem der Ansprüche 1 bis 9, bei welcher auf der Rückfläche (5) der ersten Scheibe (2) eine optische Interferenzschicht (9) zur Reflexion von Licht innerhalb eines vorgegebenen Wellenlängenbereichs angeordnet ist, wobei die Rückfläche (5) und/oder die Vorderfläche (4) jeweils mindestens einen strukturierten Bereich (8, 8') aufweist, wobei entweder die Vorderfläche (4) mindestens einen strukturierten Bereich (8) aufweist oder auf der Vorderfläche (4) eine weitere optische Interferenzschicht (9') zur Reflexion von Licht innerhalb eines vorgegebenen Wellenlängenbereichs angeordnet ist.

13. Fassadenelement (1) nach Anspruch 12, bei welcher
i) die Rückfläche (5) der ersten Scheibe (2) keinen strukturierten Bereich aufweist und die Vorderfläche (4) mindestens einen strukturierten Bereich (8) aufweist, wobei keine optische Interferenzschicht auf der Vorderfläche (4) angeordnet ist, oder
ii) die Rückfläche (5) der ersten Scheibe (2) mindestens einen strukturierten Bereich (8) aufweist und die Vorderfläche (4) mindestens einen strukturierten Bereich (8') aufweist, wobei keine optische Interferenzschicht auf der Vorderfläche (4) angeordnet ist, oder
iii) die Rückfläche (5) der ersten Scheibe (2) mindestens einen strukturierten Bereich (8) aufweist und die Vorderfläche (4) keinen strukturierten Bereich aufweist, wobei keine optische Interferenzschicht auf der Vorderfläche (4) angeordnet ist, oder
iv) die Rückfläche (5) der ersten Scheibe (2) mindestens einen strukturierten Bereich (8) aufweist und die Vorderfläche (4) keinen strukturierten Bereich aufweist, wobei eine weitere optische Interferenzschicht (9') auf der Vorderfläche (4) angeordnet ist.

14. Fassadenelement (1) nach einem der Ansprüche 1 bis 13, bei welchem die Verbundscheibe (15) aus erster Scheibe (2) und zweiter Scheibe (3) zur Formung einer Isolierscheibe über einen Abstandhalter (24) mit mindestens einer weiteren Scheibe (25) verbunden ist.

15. Verwendung des Fassadenelements (1) nach einem der Ansprüche 1 bis 14 in einer vorgehängt-hinterlüfteten Fassade, Pfosten-Riegel-Fassade oder Fensterfassade.

## Claims

1. Facade element (1) comprising a coloring transparent or semi-transparent first pane (2) and a mechanically supporting transparent second pane (3) which are firmly connected to one another by an intermediate layer (13), wherein the first pane (2) has a front surface (4) arranged on the light incidence side and an opposite back surface (5), wherein at least one surface (4, 5), selected from the front and back surfaces, has at least one structured region (8, 8'), wherein at least one optical interference layer (9, 9') is arranged on at least one surface (4, 5), selected from the front and back surfaces, for reflecting light within a predetermined wavelength range, wherein the at least one structured region (8, 8') has the following features:
- perpendicular to the plane of the first pane (2), a height profile comprising peaks and valleys, wherein an average height difference between the peaks and valleys is at least 2 µm,
- at least 50% of the structured region is composed of segments which are inclined with respect to the plane of the first pane (2), wherein, with respect to the plane of the first pane, at least 20% of the segments have an angle of inclination in the range from greater than 0° to a maximum of 15° and at least 30% of the segments have an angle of inclination in the range from greater than 15° to a maximum of 45°, wherein
- the segments are each planar and have a segment area of at least 1 µm², wherein the segments each have an average roughness of less than 15% of a layer thickness of the at least one optical interference layer.

2. Facade element (1) according to claim 1, wherein the second pane (3) is
i) thicker, or
ii) thinner
than the first pane (2).

3. Facade element (1) according to claim 1 or 2, in which
i) the first pane (2), or
ii) the second pane (3)
is arranged on the light incidence side of the intermediate layer (13).

4. Facade element (1) according to any one of claims 1 to 3, in which at least one planar back element (14) is attached to the back side (R) thereof.

5. Facade element (1) according to claim 4, in which the at least one planar back element (14) is suitable for photovoltaic energy generation.

6. Facade element (1) according to claim 5, in which the back element (14) suitable for photovoltaic energy generation comprises a carrier substrate (16) with solar cells (18), wherein the carrier substrate (16), without an intermediate pane, is firmly connected to the first pane (2) or second pane (3) by a further intermediate layer (13').

7. Facade element (1) according to claim 5 or 6, in which the first pane (2) or the second pane (3) is a cover pane of a prefabricated solar module (20).

8. Facade element (1) according to any one of claims 5 to 7, in which the planar back element (14) is smaller than the front pane (2, 3), relative to the plane of the front pane (2, 3).

9. Facade element (1) according to claim 4, in which the at least one back element is formed as:
- a coating, in particular an opaque coating, of the rear-sided first or second pane (2, 3),
- a film, in particular an opaque film, which is firmly bonded to the back-sided first or second pane (2, 3) by a transparent adhesive, in particular a transparent adhesive film, or
- a rigid body, in particular an opaque rigid body, which is firmly connected to the rear-sided first or second pane (2, 3) by a transparent adhesive means, in particular a transparent adhesive film.

10. Facade element (1) according to any one of claims 1 to 9, in which the front surface (4) of the first pane (2) has at least one structured region (8) on which an optical interference layer (9) for reflecting light within a predetermined wavelength range is arranged.

11. Facade element (1) according to claim 10, in which
i) the back surface (5) of the first pane (2) has no structured region and no optical interference layer, or
ii) the back surface (5) of the first pane (2) has no structured region and a further optical interference layer (9') is arranged on the back surface (5) of the first pane (2) for reflecting light within a predetermined wavelength range, or
iii) the back surface (5) of the first pane (2) has at least one structured region (8') on which an optical interference layer (9') for reflecting light within a predetermined wavelength range is arranged.

12. Facade element (1) according to any one of claims 1 to 9, in which an optical interference layer (9) for reflecting light within a predetermined wavelength range is arranged on the back surface (5) of the first pane (2), wherein the back surface (5) and/or the front surface (4) each have at least one structured region (8, 8'), wherein either the front surface (4) has at least one structured region (8) or a further optical interference layer (9') for reflecting light within a predetermined wavelength range is arranged on the front surface (4).

13. Facade element (1) according to claim 12, in which
i) the back surface (5) of the first pane (2) has no structured region and the front surface (4) has at least one structured region (8), wherein no optical interference layer is arranged on the front surface (4), or
ii) the back surface (5) of the first pane (2) has at least one structured region (8) and the front surface (4) has at least one structured region (8'), wherein no optical interference layer is arranged on the front surface (4), or
iii) the back surface (5) of the first pane (2) has at least one structured region (8) and the front surface (4) has no structured region, wherein no optical interference layer is arranged on the front surface (4), or
iv) the back surface (5) of the first pane (2) has at least one structured region (8) and the front surface (4) has no structured region, wherein a further optical interference layer (9') is arranged on the front surface (4).

14. Facade element (1) according to any one of claims 1 to 13, in which the composite pane (15) of first pane (2) and second pane (3) is connected to at least one further pane (25) via a spacer (24) in order to form an insulating pane.

15. Use of the facade element (1) according to any one of claims 1 to 14 in a curtain wall back-ventilated facade, post-beam facade or window facade.

## Revendications

1. Élément de façade (1),comprenant une premièrevitre(2) transparente ou semi-transparente colorée et uneseconde vitre (3) transparente pris en charge mécaniquement, reliées solidement entre elles par une couche intermédiaire (13), dans lequel lapremièrevitre (2) présentant une surface avant (4) disposée sur le côté d'incidence de la lumière et une surface arrière opposée (5), dans lequel au moins une surface (4, 5) choisie parmi les surfaces avant et arrière comporteau moins une zone structurée (8, 8'), et au moins une couche d'interférence optique (9, 9') pour réfléchir la lumière dans une plage de longueur d'onde prédéterminée est disposée sur au moins une surface (4, 5) choisie parmi les surfaces avant et arrière,
**caractérisé en ce que** la au moins une zone structurée (8, 8') présente les caractéristiques suivantes :
- perpendiculaire au plan de la première vitre (2), un profil de hauteur présentant des crêtes et des creux, une différence de hauteur moyenne entre les crêtes et les creuxétant d'au moins 2 µm,
- au moins 50 % de la zone structurée est constituée de segments qui sont inclinés par rapport au plan dela premièrevitre (2), dans lequel, par rapport au plan de la première vitre, au moins 20% des segments ont un angle d'inclinaison dans la plage allant de plus de 0° à 15° au maximum et au moins 30% des segments ont un angle d'inclinaison dans la plage allant de plus de 15° à 45°au maximum , dans lequel
- les segments sont respectivementplanaires et ont une surface de segment d'au moins 1 µm², chacun des segments ayant une rugosité moyenne inférieure à 15 % d'une épaisseur de couche de laau moins une couche d'interférence optique.

2. Élément de façade (1) selon la revendication 1, dans lequel laseconde vitre (3) est
i) plus épaisse, ou
ii) plus fine que la premièrevitre (2).

3. Élément de façade (1) selon la revendication 1 ou 2 dans lequel
i) la premièrevitre (2), ou
ii) laseconde vitre (3)
est disposéedu côté de l'incidence de la lumière de la couche intermédiaire (13).

4. Élément de façade (1) selon l'une des revendications 1 à 3, dans lequel au moins un élément arrière plat (14) est fixé sur sa face arrière (R).

5. Élément de façade (1) selon la revendication 4, dans lequel l'au moins un élément arrière plat (14) est adapté à la production d'énergie photovoltaïque.

6. Élément de façade (1) selon la revendication 5, dans lequel l'élément arrière (14) adapté à la production d'énergie photovoltaïque comprend un substrat porteur (16) avec des cellules solaires (18), le substrat porteur (16), sans vitre intermédiaire, étant relié solidairementà la premièrevitre (2) ou à lasecondevitre (3) par une autre couche intermédiaire (13').

7. Élément de façade (1) selon la revendication 5 ou 6, dans lequel la premièrevitre (2) ou la deuxième vitre (3) est une vitrede couverture d'un module solaire préfabriqué (20).

8. Élément de façade (1) selon l'une des revendications 5 à 7, dans lequel l'élément arrière plat (14) est plus petit que la vitre avant(2, 3), par rapport au plan de la vitre avant(2, 3).

9. Élément de façade (1) selon la revendication 4, dans lequel l'au moins un élément arrière est conçu comme :
- un revêtement, en particulier un revêtement opaque, de la première ou de la deuxième vitre (2, 3) disposée sur la face arrière,
- un film, en particulier un film opaque, fixé par un moyen adhésif transparent, en particulier un film adhésif transparent, qui est solidaire de la première ou de la deuxième vitre (2, 3) disposée au verso, ou secondevitre
- un corps solide, en particulier un corps solide opaque, relié solidairementà la première ou à lasecondevitre (2, 3) disposée sur la face arrière parun moyen adhésif transparent, en particulier un film adhésif transparent.

10. Élément de façade (1) selon l'une des revendications 1 à 9, dans lequel la surface avant (4) de la premièrevitre (2) présente au moins une zone structurée (8) sur laquelle est disposée une couche d'interférence optique (9) pour réfléchir la lumière dans une plage de longueurs d'onde prédéterminée.

11. Élément de façade (1) selon la revendication 10 dans lequel
i) la surface arrière (5) de la première vitre (2) ne présente pas de zone structurée et pas de couche d'interférence optique, ou
ii) la surface arrière (5) de la première vitre (2) ne comporte pas de zone structurée et une autre couche d'interférence optique (9') destinée à réfléchir la lumière dans une plage de longueurs d'onde prédéterminée est disposée sur la surface arrière (5) de la premièrevitre (2), ou
iii) la surface arrière (5) de la premièrevitre (2) présente au moins une zone structurée (8') sur laquelle est disposée une couche d'interférence optique (9') pour réfléchir la lumière dans une plage de longueurs d'onde prédéterminée.

12. Élément de façade (1) selon l'une des revendications 1 à 9, dans lequel une couche d'interférence optique (9) est disposée sur la surface arrière (5) de la première vitre (2) pour réfléchir la lumière à l'intérieur d'une plage de longueurs d'onde prédéterminée,, la surface arrière (5) et/ou la surface avant (4) présentant chacune au moins une zone structurée (8, 8'), la surface avant (4) présentant au moins une zone structurée (8) ou une autre couche d'interférence optique (9') étant disposée sur la surface avant (4) pour réfléchir la lumière à l'intérieur d'une plage de longueurs d'onde prédéterminée.

13. Élément de façade (1) selon la revendication 12 dans lequel
i) la surface arrière (5) de la premièrevitre (2) ne présente pas de zone structurée et la surface avant (4) comporte au moins une zone structurée (8), aucune couche d'interférence optique n'étant disposée sur la surface avant (4), ou
ii) la surface arrière (5) de la premièrevitre (2) présente au moins une zone structurée (8) et la surface avant (4) présente au moins une zone structurée (8'), aucune couche d'interférence optique n'étant disposée sur la surface avant (4), ou
iii) la surface arrière (5) de la premièrevitre (2) présente au moins une zone structurée (8) et la surface avant (4) ne présente pas de zone structurée, aucune couche d'interférence optique n'étant disposée sur la surface avant (4), ou
iv) la surface arrière (5) de lapremiièrevitre (2) présente au moins une zone structurée (8) et la surface avant (4) neprésente pas de zone structurée, une autre couche d'interférence optique (9') étant disposée sur la surface avant (4).

14. Élément de façade (1) selon l'une des revendications 1 à 13, dans lequel la vitrecomposite (15) constituée dela premièrevitre (2) et d'uneseconde vitre (3), est reliée à au moins une autre vitre (25) au moyen d'un écarteur (24) pour former unevitre isolante.

15. Utilisation de l'élément de façade (1) selon l'une des revendications 1 à 14 dans une façade suspendue et ventilée par l'arrière, une façade à montants et traverses, ou une façade à fenêtres.
